(19) **Europäisches Patentamt / European Patent Office / Office européen des brevets**

(11) **EP 4 611 265 A1**

(12) **EUROPEAN PATENT APPLICATION**

(43) Date of publication:
**03.09.2025 Bulletin 2025/36**

(21) Application number: **25158885.1**

(22) Date of filing: **19.02.2025**

(51) International Patent Classification (IPC):
**H03M 13/11** (2006.01)    **H03M 13/00** (2006.01)
**H04L 1/00** (2006.01)

(52) Cooperative Patent Classification (CPC):
**H03M 13/116; H03M 13/611; H03M 13/6356;
H03M 13/6516; H04L 1/0057**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2024 US 202463558718 P
31.07.2024 US 202418790358**

(71) Applicant: **Avago Technologies International
Sales
Pte. Limited
Singapore 768923 (SG)**

(72) Inventors:
• **BLANKSBY, Andrew
Irvine, 92618 (US)**
• **PULIKKOONATTU, Rethnakaran
Irvine, 92618 (US)**

(74) Representative: **Dilg, Haeusler, Schindelmann
Patentanwaltsgesellschaft mbH
Leonrodstraße 58
80636 München (DE)**

(54) **MULTI-RATE LOW-DENSITY PARITY CHECK (LDPC) CODES**

(57) An apparatus (105) may include a transmitter (120). The apparatus (105) may identify a target code rate and a low density parity check, LDPC, code that has a base code rate for a base size of information bits, select, based at least on the target data rate and the base code rate, a first size that is less than the base size of information bits, generate a second set of information bits to include a first set of information bits corresponding to the first size and one or more bits to increase a size of the second set of information to correspond to the base size of information bits, encode, using the base code rate, the second set of information bits to generate parity data, and generate a codeword by concatenating the first set of information bits and the parity data to achieve the target code rate. The transmitter (120) may transmit the codeword.

700

FIG. 7

EP 4 611 265 A1

**Description**

**Cross-Reference to Related Applications**

This application claims the benefit of and priority to U.S. Provisional Patent Application No. 63/558,718 filed on February 28, 2024, which is incorporated herein by reference in its entirety for all purposes.

**Field of the Disclosure**

This disclosure generally relates to systems and methods for improving encoding/decoding process of a communications system, including but not limited to systems and methods of constructing multi-rate low-density parity check (LDPC) codes having different code rates.

**Background**

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits parity bits to the receiver communication system. The parity bits allow the receiver communication system to verify whether the received transmission is a valid codeword and to correct errors in the transmission if the received transmission is not a valid codeword. In one approach, generating parity bits involves a complex process.

Ultra High Reliability (UHR) is a new study group within the IEEE 802.11 working group that focuses on enhancing the reliability of Wireless Local Area Network (WLAN) connectivity. Enhanced Long Range (ELR) refers to communication schemes designed to extend the range and reliability of WLANs. LDPC codes can have certain code rates that can be used as target code rates for multiple designs/implementations in communication standards (e.g., IEEE 802.11bn UHR chips).

**Brief Description of the Drawings**

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.

FIG. 2 is a schematic block diagram of a computing system, according to one or more embodiments.

FIG. 3 is a diagram depicting an example exponent matrix, according to one or more embodiments.

FIG. 4 is a diagram depicting example shifted identity matrices for generating a parity check matrix, according to one or more embodiments.

FIG. 5 is a diagram depicting an example parity check matrix, according to one or more embodiments.

FIG. 6 is a diagram depicting an example exponent matrix, according to one or more embodiments.

FIG. 7 is a diagram depicting an example multi-rate LDPC generator/encoder according to one or more embodiments.

FIG. 8 is a diagram depicting an example multi-rate LDPC decoder according to one or more embodiments.

FIG. 9 is a diagram depicting target rates achieved over different transmitted codeword sizes according to one or more embodiments

FIG. 10 is a diagram depicting an example multi-rate LDPC generator/encoder with an example code rate, according to one or more embodiments.

FIG. 11 is a diagram depicting an example multi-rate LDPC generator/encoder with another example code rate, according to one or more embodiments.

FIG. 12A and FIG. 12B are diagrams depicting example simulation results with different code rates, according to one or more embodiments.

FIG. 13A and FIG. 13B are diagrams depicting example simulation results with different code rates, according to one or more embodiments.

FIG. 14A and FIG. 14B are diagrams depicting example simulation results with different modulation configurations, according to one or more embodiments.

FIG. 15A and FIG. 15B are diagrams depicting example simulation results with different code rates, according to one or more embodiments.

FIG. 16 is a flow diagram showing a process for encoding with multi-rate LDPC codes, in accordance with an embodiment.

The details of various embodiments of the methods and systems are set forth in the accompanying drawings and the description below.

## Detailed Description

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

Although various embodiments disclosed herein are described for encoding and/or decoding data for a wireless communication (e.g., wireless local area network (WLAN) conforming to any IEEE 802.11 standard including IEEE 802.11bn), principles disclosed herein are applicable to other types of communication (e.g., wired communication) or any process that performs encoding for error correction codes (e.g., low-density parity check (LDPC) codes, forward error correction (FEC) codes).

I. LDPC-Based Encoding/Decoding Systems

Generally, a parity check matrix for a code represents equations that determine whether errors have occurred during transmission. More formally, for all valid codewords (i.e., bits produced by the encoder with no errors), the following equation can be true:

$$Hc=0 \ \text{................} \ \text{(Equation 1)}$$

In Equation 1, "H" is the parity check matrix, "c" is a codeword vector, and "0" is a vector of all zeroes. The parity check matrix, H, is one way of describing a code.

A generator matrix for a code, G, satisfies the following equation:

$$sG=c \ \text{................} \ \text{(Equation 2)}$$

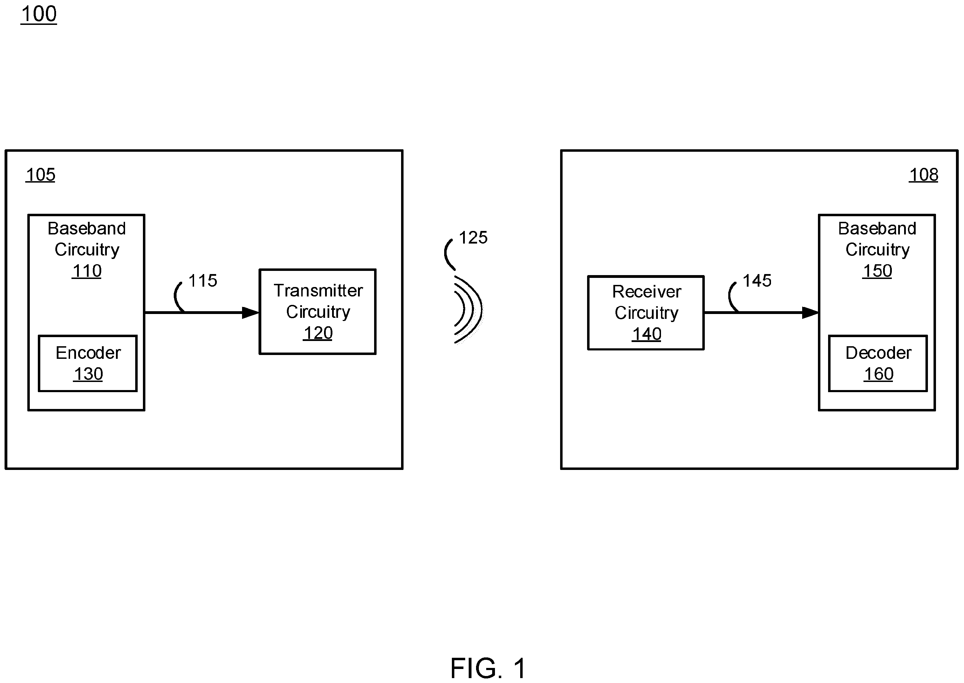

In Equation 2, "s" is a vector of information bits, "G" is a generator matrix and "c" is the codeword that corresponds to "s." In some implementations, a system (e.g., a communication system 108 including a decoder 160 in FIG. 1) can decode the codeword c to obtain the decoded data s using Equation 2.

The parity check and generator matrices for a code are related per the above matrix equations. Generally, if a parity check matrix is low density, the corresponding generator matrix will be high density, and vice versa. LCPC codes are accordingly characterized by low density parity check matrices and high density generator matrices. The density of a matrix relates to the number of operations that must be performed to implement one of the above equations. Although it was recognized by 1995 that LDPC codes could be used to transmit data with very few errors, i.e., with error rates as good or better than turbo codes, one disadvantage of LDPC codes is that their generator matrices were high density and that made encoding computationally intensive, rending the codes impractical for many applications.

In some implementations, a parity check matrix may have a quasi-cyclic structure, for example, a parity check matrix for QC-LDPC code (n=3888, k=2916, R=3/4). Given a lifting size z, the parity check matrix may have a plurality of sub-matrices such that each submatrix is cyclically shifted version of an identity matrix of size (z x z), where z=162, for example. A parity check matrix can be represented in two equivalent forms: (1) parity check matrix H and (2) a block matrix or an exponent matrix P=E(H).

In some implementations, a parity check matrix H may be a binary matrix whose size is m x n (each of m and n is an integer). Elements of the parity check matrix are binary values. Given a block length n and a code rate R, an LDPC code (or QC-LDPC code) LDPC (n, R) satisfies the following equations:

$$k=nR \dots\dots\dots\dots \text{(Equation 3)}$$

$$m=n(1\text{-}R) \dots\dots\dots\dots \text{(Equation 4)}$$

In some implementations, a block matrix or an exponent matrix (QC-LDPC exponent matrix) may be obtained. Given a lifting size z, the exponent matrix P=E(H) may have a size of m/z x n/z. If n=24z (e.g., n=3888, z=162), then the size of P=E(H) is 24(1-R) x 24 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). The exponent matrix P=E(H) may have a structure including a plurality of sub-matrices (e.g., A, B, C, D, E, T).

In some implementations, a binary QC-LDPC code LDPC (n, R) may be characterized by the null space of an n(1-R)×n parity check matrix H. The parity check matrix H may be a binary sparse matrix which includes a set of circulant matrices of size z x z. The parity-check matrix H of a QC-LDPC code can be represented equivalently by an exponent matrix P=E(H). This representation can help to illustrate the graphical structure of the underlying code as a base graph along with coefficient of shifting.

In some implementations, a parity check matrix H may be generated from an exponent matrix P=E(H). The exponent matrix P=E(H) may include (as elements) shift values d in the range 0<=d<z along with d=-1. For example, if z=7, the shift values d may include -1, 0, 1, 2, 3, 4, 5, 6. The shift value d=0 may correspond (or map) to an identity matrix of size z x z, denoted by I(z). The shift value d=-1 may correspond (or map) to a null matrix (all elements zero) of size z x z, denoted by 0*I(z). Any other integer value d in [1,z-1] may correspond (or map) to a matrix cyclically right shifted from I(z). The parity check matrix H can be obtained from the exponent matrix P=E(H) by expanding the exponent matrix P such that each element of the exponent matrix P (as a shift value d) is replaced by a matrix corresponding to the shift value.

In some implementations, the exponent matrix P=E(H) may include a plurality of elements P1,1, P1,2, P1,3, ..., P1,ń; P2,1, P2,2, P2,3, ..., P2,ń; ..., P1,1, P1,2, P1,3, ..., Pm̂,ń, which correspond to (m x ń) values where m̂ and ń satisfy the following equations:

$$m̂= n(1\text{-}R)/z \dots\dots\dots\dots \text{(Equation 5)}$$

$$ń = n/z \dots\dots\dots\dots \text{(Equation 6)}$$

The exponent matrix (or permutation matrix) P=E(H) may be expressed as following:

$$P \equiv E(H) = \begin{pmatrix} P_{1,1} & P_{1,2} & P_{1,3} & \cdots & \cdots & P_{1,ń} \\ P_{2,1} & P_{2,2} & P_{2,3} & \cdots & \cdots & P_{2,ń} \\ \cdots & \ddots & \ddots & \cdots & \cdots & \vdots \\ P_{m̂,1} & P_{m̂,2} & P_{m̂,3} & \cdots & \cdots & P_{m̂,ń} \end{pmatrix}$$

(Equation 7)

The corresponding parity check matrix H may be obtained by replacing each element of the matrix (as a shift value d) by a matrix C(d) corresponding to the shift value as follows:

$$H = \begin{pmatrix} C(P_{1,1}) & C(P_{1,2}) & C(P_{1,3}) & \ldots & \ldots & C(P_{1,\hat{n}}) \\ C(P_{2,1}) & C(P_{2,2}) & C(P_{2,3}) & \ldots & \ldots & C(P_{2,\hat{n}}) \\ \ldots & \ddots & \ddots & \ldots & \ldots & \vdots \\ C(P_{\hat{m},1}) & C(P_{\hat{m},2}) & C(P_{\hat{m},3}) & \ldots & \ldots & C(P_{\hat{m},\hat{n}}) \end{pmatrix}$$

$$\ldots\ldots\ldots\ldots \text{(Equation 8)}$$

For example, a matrix C(1) may be expressed as follows:

$$C(1) = \begin{pmatrix} 0 & 1 & 0 & \ldots & \ldots & 0 \\ 0 & 0 & 1 & \ldots & \ldots & \ddots \\ \ddots & \ddots & \ddots & \ldots & \ldots & \vdots \\ 0 & 0 & 0 & \ldots & \ldots & 1 \\ 1 & 0 & 0 & \ldots & \ldots & 0 \end{pmatrix}$$

$$\ldots\ldots\ldots\ldots \text{(Equation 9)}$$

In some implementations, an encoder can produce codewords using a generator matrix (e.g., using Equation 2). In some implementations, an encoder can use the parity check matrix (rather than the generator matrix) to produce codewords from vectors of information bits. After a parity check matrix H is obtained, the parity check matrix H may have sub-matrices A, B, C, D, T, E. An upper area O of the sub-matrix T may correspond to an area in which the matrix contains all zeroes, and the other areas may represent locations that can contain ones.

In some implementations, the codeword c can be obtained by the following expression:

$$c = [s\ p1\ p2] \ldots\ldots\ldots\ldots \text{(Equation 10),}$$

where "s" is the vector of information bits to be encoded, "$p_1$" is a vector of the first g parity bits and "$p_2$" is a vector of the remaining m-g parity bits.

The vectors p1 and p2 can be obtained by the following equations:

$$\Phi = -ET^{-1}B+D \ldots\ldots\ldots\ldots \text{(Equation 11);}$$

$$p_1^T = -\Phi^{-1}(-ET^{-1}A+C)\ s^T \ldots\ldots\ldots\ldots \text{(Equation 12);}$$

and

$$p_2^T = -T^{-1}(As^T+Bp_1^T) \ldots\ldots\ldots\ldots \text{(Equation 13).}$$

Although various embodiments disclosed herein are described for encoding data for a wireless communication (e.g., wireless local area network (WLAN) conforming to any IEEE 802.11 standard), principles disclosed herein are applicable to other types of communication (e.g., wired communication) or any process that performs encoding for LDPC codes.

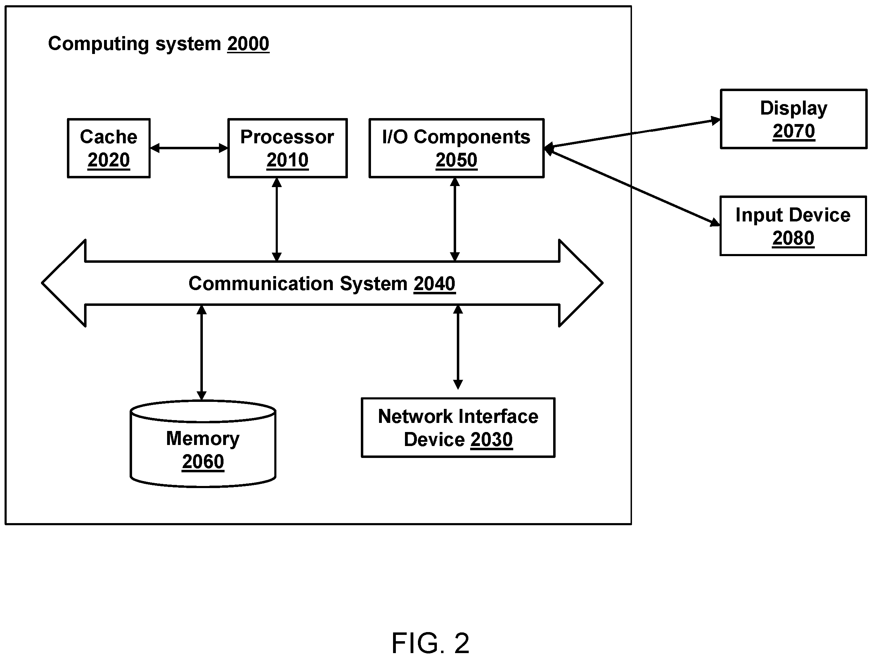

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some implementations, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some implementations, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data and generates or outputs parity bits. In one aspect, the baseband circuitry 110 (or encoder 130) obtains a generator matrix or a parity check matrix or uses a previously produced generator matrix or a previously produced parity check matrix and encodes the information data by applying the information data to the generator matrix or the parity check matrix to obtain a codeword. In some implementations, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix and appends the parity bits to the information bits to form a codeword. The baseband circuitry 110 generates the baseband data 115 including the codeword for the communication system 108 and provides the baseband data 115 to the transmitter circuitry 120.

The transmitter circuitry 120 of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna (not shown). In this configuration, the transmitter circuitry 120 up-converts the baseband data 115 from the baseband circuitry 110 onto a carrier signal to generate the wireless signal 125 at a radio frequency (RF) frequency (e.g., 10 MHz to 60 GHz), and transmits the wireless signal 125 through the antenna.

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna (not shown). In this configuration, the receiver circuitry 140 receives the wireless signal 125 though an antenna, and down-converts the wireless signal 125 at an RF frequency according to a carrier signal to obtain the baseband data 145 from the wireless signal 125. The receiver circuitry 140 then provides the baseband data 145 to the baseband circuitry 150.

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some implementations, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2 and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multi-core processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors. For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

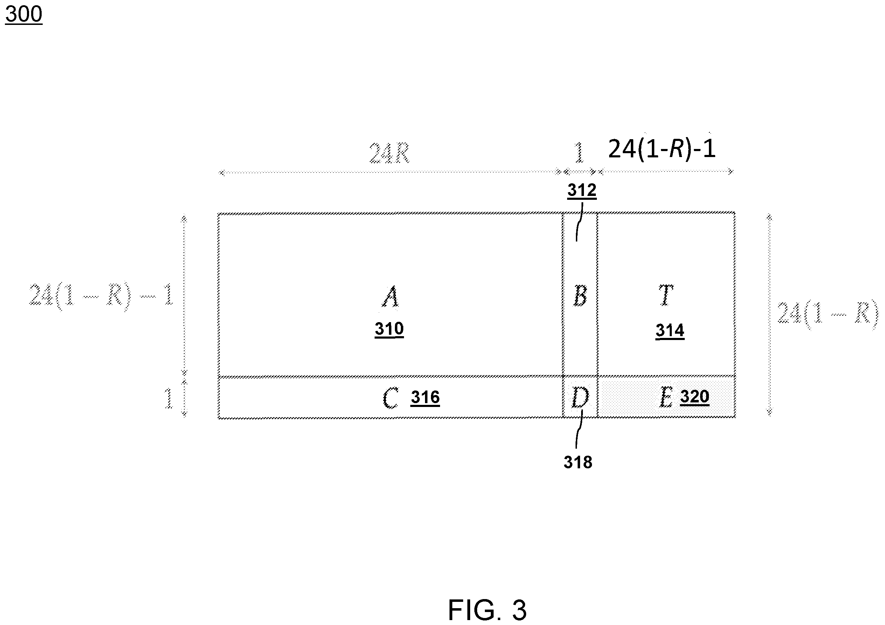

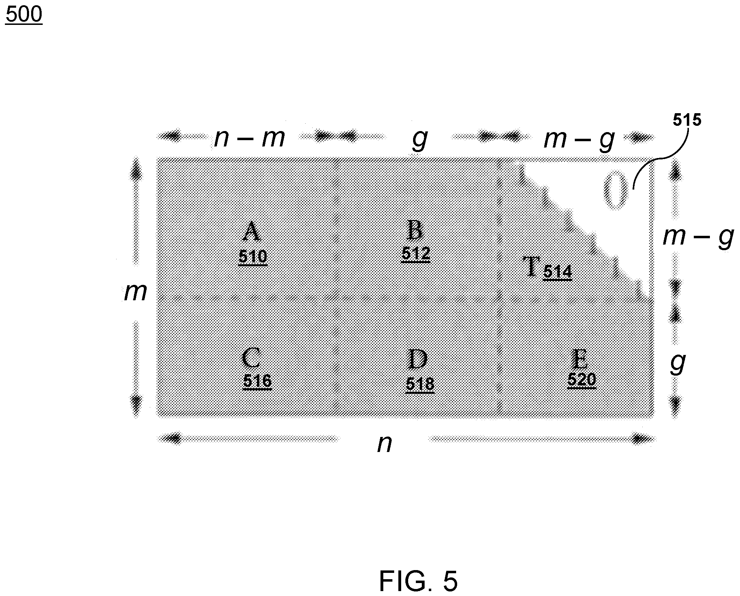

FIG. 3 is a diagram depicting an example exponent matrix (QC-LDPC exponent matrix) 300, according to one or more embodiments. Given a lifting size z, the exponent matrix 300 may have a size of m/z x n/z. If n=24z (e.g., n=3888, z=162), then the size of P=E(H) is 24(1-R) x 24 (= n(1-R)/z x n/z). Elements of the exponent matrix may be integer values which correspond to cyclic shift values of identity matrix of size z x z. A parity check matrix H (see FIG. 5) may be a sparse binary matrix that can be derived from an exponent matrix P=E(H). The generator matrix G may have a size n x k in binary form (e.g., elements of the generator matrix G are binary values). Referring to FIG. 3, the exponent matrix P=E(H) may have a structure including a plurality of sub-matrices (e.g., A 310, B 312, C 316, D 318, E 320, T 314).

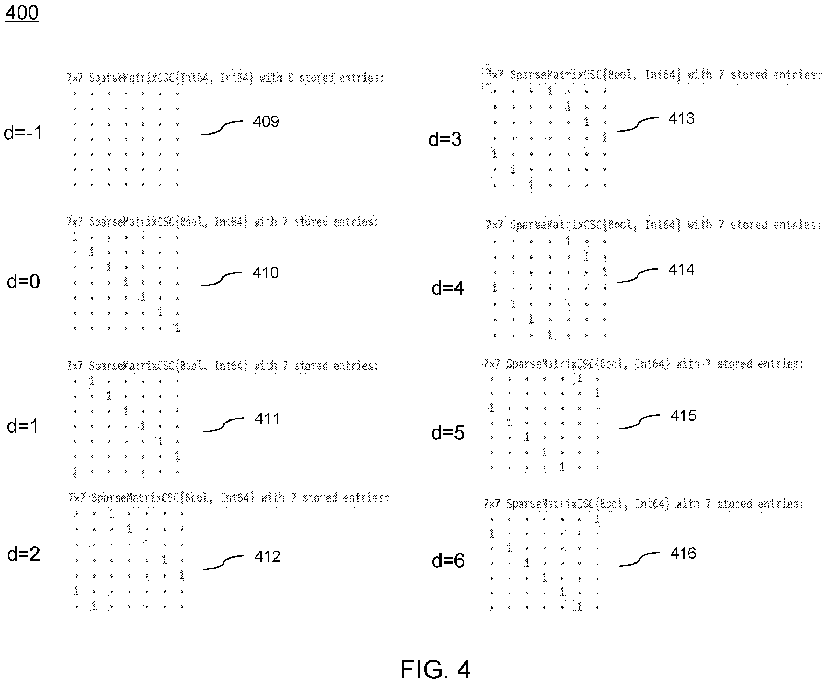

FIG. 4 is a diagram 400 depicting example shifted identity matrices 409, 410, 411, 412, 413, 414, 415, 416 for generating a parity check matrix, according to one or more embodiments. A parity check matrix H may be generated from an exponent matrix P=E(H) (e.g., exponent matrix 300) or may be identified using a codebook. As shown in Equation 7, the exponent matrix P=E(H) may include (as elements) shift values d in the range 0<=d<z along with d=-1. See Equation For example, if z=7, the shift values d may include -1, 0, 1, 2, 3, 4, 5, 6 (see FIG. 4). The shift value d=0 may correspond (or map) to an identity matrix of size z x z, denoted by I(z) (e.g., matrix 410). The shift value d=-1 may correspond (or map) to a null matrix (all elements zero) of size z x z, denoted by 0*I(z) (e.g., matrix 409). Any other integer value d in [1,z-1] may correspond (or map) to a matrix cyclically right shifted from I(z) (e.g., matrices 411, 412, 413, 414, 415, 416). As shown in Equation 8, the parity check matrix H can be obtained from the exponent matrix P=E(H) by expanding the exponent matrix P such that each element of the exponent matrix P (as a shift value d) is replaced by a matrix corresponding to the shift value.

FIG. 5 is a diagram depicting an example parity check matrix 500, according to one or more embodiments. In some implementations, an encoder (e.g., encoder 130) can produce codewords using a generator matrix (e.g., using Equation 2). In some implementations, an encoder (e.g., encoder 130) can use the parity check matrix (rather than the generator matrix) to produce codewords from vectors of information bits. After a parity check matrix H is obtained (e.g., using a codebook), the parity check matrix H (e.g., parity check matrix 500) may have sub-matrices A 510, B 512, C 516, D 518, T 514, E 520. An upper area O 515 of the sub-matrix T 514 (e.g., white area in FIG. 5) may correspond to an area in which the matrix contains all zeroes, and the other areas (e.g., grey area in FIG. 5) may represent locations that can contain ones. The size of the parity check matrix 500 may be m x n where the size of the sub-matrix D 518 is g x g, and the size of the sub-matrix T is (m-g)x(m-g). In some implementations, given a vector s of information bits to be encoded, the encoder can obtain a codeword c using Equation 10, Equation 11, Equation 12 and Equation 13.

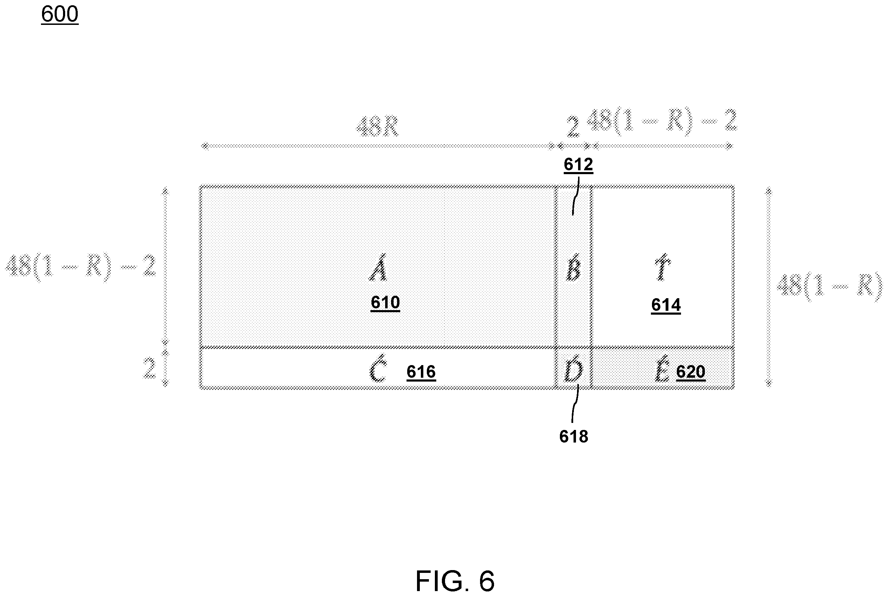

FIG. 6 is a diagram depicting an example exponent matrix (QC-LDPC exponent matrix) 600, according to one or more embodiments. Given a lifting size z, the exponent matrix 600 may have a size of m/z x n/z. If n=48z (e.g., n=3888, z=81), then the size of P=E(H) matrix for n=3888 is 48(1-R) x 48 (= n(1-R)/z x n/z). Elements of the exponent matrix may be integer values which correspond to cyclic shift values of identity matrix of size z x z. A parity check matrix H may be a sparse binary matrix that can be derived from an exponent matrix P=E(H). The generator matrix G may have a size n x k in binary form (e.g., elements of the generator matrix G are binary values). Referring to FIG. 6, the exponent matrix Ṕ=E(H) may have a structure including a plurality of sub-matrices (e.g., Á 310, B 312, Ć 316, Ḋ 318, É 320, Ť 314).

## II. Multi-Rate LDPC Codes

In one aspect, LDPC codes can have certain code rates that can be used as target code rates for multiple designs/implementations in communication standards (e.g., IEEE 802.11bn UHR chips). An LDPC encoder may take a block of k bits of information bits (e.g., k=1458) and produce n coded bits with the code rate R=k/n (e.g., R=3/4, n=1944). The LDPC codes refer to systematic LDPC codes, quasi-cyclic (QC) LDPC codes or any error correction code using a parity check matrix which is defined as a set of equations that are satisfied by any valid code word. The code rate R of an LDPC code refers to a ratio of the number of information bits (denoted by k) to the code block size (denoted by n). An LDPC decoder may operate on (noisy version of ) n received bits and (ideally) recover the k information bits. However, a conventional LDPC code may have a fixed code rate R for a fixed size of information bits k, and LDPC codes with different code rates may not be easily constructed (or generated, configured, designed, implemented).

To solve this problem, systems and methods according to some embodiments of the present disclosure can construct/generate/configure/design/implement, based on a base LDPC code (or a mother LDPC code) multi-rate low-density parity check (LDPC) codes having different code rates (e.g., code rate of 1/3, ¼, 1/8, 2/5, 3/8, or 7/16).

In some implementations, the systems and methods can derive codes (e.g., multi-rate LDPC codes) from an appropriate mother code. For example, mother codes may be existing base codes from the IEEE 802.11n/802.11be standard specification; however embodiments of the present disclosure are not limited/restricted to the IEEE 802.11 codes.

In some implementations, the systems and methods can construct codes having different rates based on one or more parameters. The one or more parameter may include, for example, a desired code rate denoted by r, information block length/size denoted by k (e.g., number of information bits), and/or Tx-CW (transmit codeword) size or code block size denoted by n. The one or more parameters may be tunable to meet one or more design criteria.

In some implementations, the systems and methods may perform second-level optimization in the form of a permutation pattern (denoted by Π) or a masking pattern, to reduce a coded bit error rate or a frame error probability. The permutation pattern or masking pattern may be chosen a priori. In some implementations, before being input to an LDPC encoder, information bits may be permutated using a chosen a priori permutation pattern, or changed using a chose prior masking patter. In some implementations, the systems and methods can bypass this second-level optimization for a simpler scheme.

In some implementations, a system for generating one or more multi-rate LDPC codes and/or encoding with the one or more multi-rate LDPC codes (also referred to as "multi-rate LDPC generator" or "multi-rate LDPC encoder") may include an LDPC encoder, an information bits optimizer, and/or a multiplexer (MUX). The multi-rate LDPC generator/encoder and each component thereof may be implemented using circuitry, firmware and/or software. The LDPC encoder may take a block of k bits of information bits and produce n coded bits (or codeword or coded block) with the code rate R=k/n.

In some implementations, the information bits optimizer may include a bit permutation pattern or permutation pattern (denoted by Π) and/or masked bits (or bitmask). The permutation pattern may define or indicate how input bits can be permutated. In some In some implementations, the permutation pattern and/or the masked bits may be chosen a priori. In some implementations, the permutation pattern and/or the masked bits may be stored in memory. In some implementations, given k information bits, the permutation pattern may define, indicate, or store an index to one permutation of all permutations of k information bits (e.g., an index to one permutation of all k! permutations). For example, the permutation pattern may indicate one of 1, 2, ..., k!, each of which indicates a permutation of k information bits. In some implementations, the bitmask may be an array of bits whose size is equal to k information bits such that each bit of the bitmask indicates whether to keep or clear the corresponding bit of the k information bits. The information bits optimizer may be configured to perform bitwise or bit operations (e.g., NOT, AND, OR, XOR, shift, swap, etc.) to perform permutation (using the permutation pattern Π) and/or bitmasking (using the bitmask) on the k information bits.

In some implementations, a system (e.g., a communication system, a multi-rate LDPC generator/encoder) may obtain data of coded bit error rate and/or frame error probability (from past measurements or simulations for example), and determine, based on the bit error rates and/or frame error probability and prior to generating multi-rate LDPC codes, the permutation pattern and/or the bitmask. Here, the coded bit error rate (BER) refers to a number of coded bit errors per unit time where the number of coded bit errors refers to a number of received coded bits of a data stream that have been altered due to errors (e.g., noise, interference, distortion or any other bit errors). The bit error probability (FEP) refers to an expected value (e.g., mean, or weighted average) of a bit error ratio, where the bit error ratio refers to a number of bit errors divided by the total number of transferred bits during a certain time interval. The system may determine the permutation pattern to reduce the BER or FEP (e.g., by permuting particular bits that are highly affected by BER or FEP). The system may determine the bitmask to reduce the BER or FEP (e.g., by clearing particular bits that are highly affected by BER or FEP).

In some implementations, the system can monitor data streams (e.g., transmission of digitally encoded signals) over a communication channel, determine or measure a coded BER and/or an FEP from the monitored data streams, and use the measured coded BER and/or an FEP to dynamically determine the permutation pattern and/or the bitmask. In some implementations, the system or the multi-rate LDPC generator/encoder can be tunable to set the permutation pattern and/or the bitmask to different pattern/bitmasking values.

In some implementations, the system may receive/determine/identify a desired code rate (or target code rate) denoted by r (e.g., r=1/3) and a (base) code rate of a base LDPC code (e.g., R=1/2). In some implementations, the system may first determine a target code rate r and then determine, based on the target code rate r, a base code rate R (or one or more base code rates). In some implementations, the system may first determine a base code rate R and then determine, based on the base code rate R, a target code rate r (or one or more target code rates).

In some implementations, the system may determine, based on the base code rate (e.g., R=1/2), values of k and n (e.g., k=822, n=1944). In some implementations, the base LDPC code may have (or be associated with) a code rate R, a codeword length (or coded block length) n, and an information bits size k (e.g., n=648,1296,1944,3888 if the base code is chosen from the 802.11n-be standards).

In some implementations, the system may determine a parameter of $\acute{k}$ indicating the size of information bits ($\acute{k} < k$; e.g., $\acute{k}$ = 486) for the target rate r (e.g., r=1/3). In some implementations, the parameter $\acute{k}$ may be chosen a priori for a target rate r. In some implementations, the system may determine the value of $\acute{k}$ as follows:

$$\acute{k} = \text{r} * \frac{1-\text{R}}{1-\text{r}} \ldots\ldots\ldots (\text{Equation 14}).$$

In some implementations, the system may determine a parameter of $\acute{n}$ indicating a coded block length (or codeword size; e.g., $\acute{n}$ =1458) for the target rate r (e.g., r=1/3). In some implementations, the system may determine the value of $\acute{n}$ as follows:

$$\acute{n} = \text{n} * \frac{1-\text{R}}{1-\text{r}} \ldots\ldots\ldots (\text{Equation 15}).$$

In some implementations, the system may determine a parameter of $(k - \acute{k})$ indicating a frozen block length or a size of one or more bits added to the $\acute{k}$ information bits $(k - \acute{k}$ = 486) for the target rate r (e.g., r=1/3). In some implementations, the system may determine the parameter $(k - \acute{k})$ as follows:

$$(k - \acute{k}) = \frac{\text{R}-\text{r}}{1-\text{r}} \ldots\ldots\ldots (\text{Equation 16}).$$

With the parameters determined above (e.g., $\acute{k}, \acute{n}$), the target rate r can be calculated as follows:

$$r = \frac{\acute{k}}{\acute{n}} = \frac{\acute{k}}{\text{n}-\text{k}+\acute{k}} \ldots\ldots\ldots (\text{Equation 17}).$$

In some implementations, the system may calculate/compute/obtain possible combinations of parameters (e.g., r, R, $\acute{n}, \acute{k}$) using Equation 14 to Equation 17 (such that $\acute{n}, \acute{k}$ should be integer values), store the resulting parameter combinations in memory (e.g., in the form of look-up table (LUT)), and determine parameters by selecting a parameter combination from the LUT. Table 1 shows an example LUT including possible parameter combinations.

Table 1. Possible Parameter Combinations for Multi-Rate LDPC Codes

| $\acute{k}$ | $\acute{n}$ | r (fractions) | R (base rate) | r (decimals) |
|---|---|---|---|---|
| 486 | 1458 | 1/3 | 1/2 | 0.3333 |
| 648 | 1620 | 2/5 | 1/2 | 0.4 |
| 1080 | 1728 | 5/8 | 2/3 | 0.625 |
| 810 | 1296 | 5/8 | 3/4 | 0.625 |
| 540 | 864 | 5/8 | 5/6 | 0.625 |
| 756 | 1728 | 7/16 | 1/2 | 0.4375 |
| 504 | 1152 | 7/16 | 2/3 | 0.4375 |
| 378 | 864 | 7/16 | 3/4 | 0.4375 |
| 252 | 576 | 7/16 | 5/6 | 0.4375 |
| 324 | 1296 | 1/4 | 1/2 | 0.25 |
| 216 | 864 | 1/4 | 2/3 | 0.25 |
| 162 | 648 | 1/4 | 3/4 | 0.25 |
| 108 | 432 | 1/4 | 5/6 | 0.25 |
| 139 | 1111 | 139/1111 | 1/2 | 0.1251 ($\approx$1/8) |

Using Table 1, the system can first determine a target code rate r and then determine/select/choose, based on the target code rate r, one or more base code rates R. For example, for the target rate r=5/8, the system can select one or more base code rates R=2/3, 3/4, 5/6. In some implementations, using Table 1, the system can first determine a base code rate R and then determine, based on the base code rate R, one or more target code rates. For example, for the base rate R=1/2, the system can select one or more target code rates r=1/3, 2/5, 7/16, 1/4, 139/1111.

In some implementations, the system may receive $\acute{k}$ information bits for the target code rate r. Next, the system may add $(k - \acute{k})$ bits to the $\acute{k}$ information bits at the end thereof to form/generate k information bits for the base code rate R. In some implementations, the added $(k - \acute{k})$ bits may be zero (e.g., $(k - \acute{k})$ number of binary zeros). In some implementations, the added $(k - \acute{k})$ bits may include one or more binary ones.

In some implementations, in response to adding $(k - k)$ bits to the k information bits, the information bits optimizer may receive the resulting k information bits, perform at least one of permutation using the permutation pattern $\Pi$ or bitmasking using the bitmask, and generate optimized k information bits. In some implementations, the system may control the information bits optimizer to dynamically turn on or off, thereby selectively skipping permutation and/or bitmasking for simplicity without overly compromising the performance of the resulting multi-rate code. In some implementations, the system may determine a degree of coded BER or FEP is less than a threshold, and turn off the information bits optimizer to skip permutation and bitmasking.

In some implementations, in response to the information bits optimizer generating the optimized k information bits (or in response to adding $(k - \acute{k})$ bits to the $\acute{k}$ information bits if the information bits optimization is skipped), the LDPC encoder may receive k information bits, and encode the k information bits to generate k encoded bits and $(n-k)$ parity bits. In response to generating the $(n-k)$ parity bits, the MUX may receive, as two inputs, the $\acute{k}$ information bits and the $(n-k)$ parity bits, and generate/output $(n - k + k)$ bits by concatenating (or combining, merging, integrating, consolidating) the $\acute{k}$ information bits and the $(n-k)$ parity bits. The output $(n - k + \acute{k})$ bits may correspond to a codeword for the multi-rate LDPC code with target rate r. In other words, the multi-rate LDPC encoder can encode the k information bits to generate the $(n - k + \acute{k})$ encoded bits (or a codeword) such that the code rate of the multi-rate LDPC encoder corresponds to

$$r = \frac{\acute{k}}{n-k+\acute{k}} \text{ (Equation 17).}$$

.

In some implementations, a system for decoding encoded bits using one or more multi-rate LDPC codes (also referred to as "multi-rate LDPC decoder") may include an LDPC decoder, a LLR values optimizer, a multiplexer (MUX), and/or a bits de-optimizer (or inverse optimizer). The multi-rate LDPC decoder and each component thereof may be implemented using circuitry, firmware and/or software. The LDPC decoder may take a block of *n* encoded bits and produce *k* decoded bits (or decoded information bits) with the code rate R=k/n.

In some implementations, the LLR values optimizer may have configuration similar to the information bits optimizer in the multi-rate LDPC encoder. For example, the LLR values optimizer may be configured to perform permutation (using a permutation pattern Π) and/or bitmasking (using a bitmask) on input LLR values (e.g., k LLR values). The bits de-optimizer may be configured to perform an inverse operation of the information bits optimizer in the multi-rate LDPC encoder.

In some implementations, the multi-rate LDPC decoder may receive $(n - k + \acute{k})$ log likelihood ratio (LLR) values including $\acute{k}$ LLR values (corresponding to $\acute{k}$ information bits) and *(n-k)* LLR values (corresponding to *(n-k)* parity bits). The multi-rate LDPC decoder may obtain/extract, from the *k* LLR values, *k* LLR values by removing *(k - k)* LLR values at the end of the $\acute{k}$ LLR values. The removed *(k - k)* LLR values may correspond to the *(k - k)* bits (e.g., *(k - $\acute{k}$)* zeros) added to the $\acute{k}$ information bits by the corresponding multi-rate LDPC encoder.

In some implementations, the multi-rate LDPC decoder may generate, by the LLR values optimizer, k optimized LLR values. In some implementations, the multi-rate LDPC decoder may turn off the LLR values optimizer to skip permutation and bitmasking.

In some implementations, in response to the LLR values optimizer generating the optimized *k* optimized LLR values (or in response to extracting, from the $\acute{k}$ LLR values, *k* LLR values if the LLR values optimization is skipped), the MUX may receive, as two inputs, the k (optimized) LLR values and the *(n-k)* LLR values, and generate/output n LLR values by concatenating (or combining, merging, integrating, consolidating) the *k* LLR values and the *(n-k)* LLR values.

In some implementations, the LDPC decoder may receive the n LLR values as an output from the MUX, and decode the *n* LLR values to generate *k* information bits. In some implementations, in response to determining that the corresponding multi-rate LDPC encoder has performed the information bits optimization, the bits de-optimizer may be configured to receive the k information bits from the LDPC decoder, and perform, based on the permutation pattern Π or the bitmask in the multi-rate LDPC encoder, bitwise or bit operations to perform an inverse permutation and/or inverse bitmasking on input bits (e.g., *k* information bits). If the corresponding multi-rate LDPC encoder does not perform the information bits optimization, the multi-rate LDPC decoder may not perform the inverse bits optimization (e.g., by turning off the bits de-optimizer).

In some implementations, in response to the bits de-optimizer generating the de-optimized *k* information bits (or in response to the LDPC decoder generating the *k* information bits if the corresponding multi-rate LDPC encoder does not perform the information bits optimization), the multi-rate LDPC decoder may extract, from the k information bits, $\acute{k}$ information bits at the start of the *k* information bits, and output the $\acute{k}$ information bits. The outputted $\acute{k}$ information bits may correspond to information bits for the multi-rate LDPC code with target rate r. In other words, the multi-rate LDPC decoder can decode the *(n - k + k)* LLR values to generate the *k* information bits such that the code rate of the multi-rate LDPC decoder corresponds to $r = \dfrac{k}{n-k+\acute{k}}$ (Equation 17).

In some implementations, an apparatus (e.g., a communication device including a transmitter and an encoder) may include a transmitter (e.g., transmit circuitry) and one or more processors. The one or more processors may be configured to identify a target code rate denoted by r and an LDPC code (e.g., base LDPC code or mother LDPC code) that has a base code rate denoted by R for a base size of information bits (denoted by k). The LDPC code refers to a systematic LDPC code or QC-LDPC code or any code that can define a parity check matrix H or a block matrix or an exponent matrix P=E(H). The base code rate refers to a code rate of an LDPC code that is a ratio of a size of information bits to a size of encoded bits produced by an LDPC encoder with an input of the information bits. The LDPC encoder refers to any circuitry, firmware or software that receives information bits and produce, based on the information bits using an LDPC code, a set of bits and parity bits (or parity data) associated with the set of bits. The parity bits (or parity data) associated with a set of bits refer to an error-detecting code that indicates whether the total number of 1-bits in the set of bits is even or odd. The target code rate refers to a desired code rate that is a ratio of a size of information bits to a size of encoded bits produced with input of the information bits by a system (e.g., multi-rate LDPC encoder) including an LDPC encoder in which the information bits are different from information bits inputted to the LDPC encoder and the encoded bits are different from encoded bits produced by the LDPC encoder. The information bits refer to any binary data inputted to an encoder to produce binary encoded data based on the binary input data.

The one or more processors may be configured to select, based at least on the target data rate (denoted by r) and the base code rate (denoted by R), a first size of information bits that is less than the base size of information bits. The one or more processors may be configured to generate a second set of information bits to include a first set of information bits corresponding to the first size of information bits and one or more bits to increase a size of the second set of information to correspond to the base size of information bits. The one or more processors may be configured to encode, using the base code rate, the second set of information bits to generate parity data. The one or more processors may be configured to generate a codeword by concatenating the first set of information bits and the parity data to achieve the target code rate. The transmitter may be configured to transmit the codeword. The codeword refers to encoded version of original information bits inputted to an encoder or any output data that is generated by an encoder based on original information bits.

In some implementations, the target code rate may be smaller than the base code rate. In some implementations, in generating the second set of information bits, the one or more processors may be configured to determine, based at least on the target data rate and the base code rate, a second size of the one or more bits. The one or more processors may be configured to generate the one or more bits corresponding to the second size of the one or more bits.

In some implementations, the one or more processors may be configured to determine, based at least on a coded bit error rate or a frame error probability, a set of masked bits corresponding to the base size of information bits. The masked bits (also referred to mask or bitmask) refer to any data (e.g., binary data or any other data) that define which bits of binary data are to be kept, cleared or toggled within the binary data.

The one or more processors may be configured to generate, based at least on the set of masked bits and the second set of information bits, a third set of information bits corresponding to the base size of information bits. The one or more processors may be configured to encode, using the base code rate, the third set of information bits to generate second parity data. The one or more processors may be configured to generate the codeword by concatenating the first set of information bits and the second parity data to achieve the target code rate.

In some implementations, the second set of information bits may be encoded using the identified LDPC code to generate the parity data. In some implementations, a ratio of the first size of information bits to a size of the codeword may be equal to the target code rate.

In some implementations, the one or more processors may be configured to identify, based at least on the target code rate, one or more LDPC codes to achieve the target code rate. Each of the one or more LDPC codes may be a base code rate different from the base code rate of the LDPC code, for a base size of information bits different from the base size of information bits of the LDPC code.

Embodiments in the present disclosure have at least the following advantages and benefits. Embodiments in the present disclosure can provide useful techniques for constructing/generating/configuring/designing/implementing multi-rate low-density parity check (LDPC) codes for long range modes and providing potentially new data rates that can be considered for communication standards (e.g., UHR/IEEE 802.11bn). In some implementations, systems and methods can construct LDPC codes with simple design and in a manner of hardware and implementation friendly. For example, LDPC codes can be constructed by re-using existing codes.

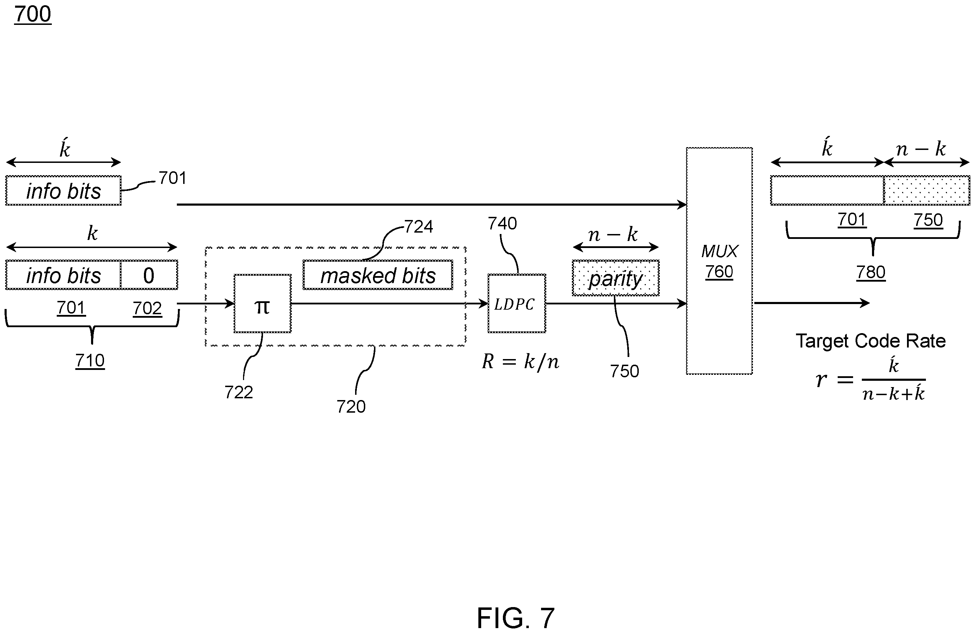

Referring to FIGS. 7-16, embodiments of systems and methods for the present solution to provide multi-rate LDPC codes having different code rates are described and illustrated.

FIG. 7 is a diagram depicting an example multi-rate LDPC generator/encoder 700 according to one or more embodiments. The multi-rate LDPC generator/encoder 700 may include an LDPC encoder 740, an information bits optimizer 720, and/or a MUX 760. The multi-rate LDPC generator/encoder 700 and each component thereof may be implemented using circuitry, firmware and/or software. For example, the multi-rate LDPC generator/encoder 700 may be implemented in the encoder 130 of the communication system 105. The LDPC encoder 740 may take a block of k bits of information bits and produce n coded bits (or codeword or coded block) with the code rate R=k/n.

Referring to FIG. 7, the information bits optimizer 720 may include a bit permutation pattern or permutation pattern 722 (denoted by $\Pi$) and/or masked bits 724 (or bitmask). The permutation pattern 722 may define or indicate how input bits can be permutated. The permutation pattern 722 and/or the masked bits 724 may be chosen a priori. The permutation pattern 722 and/or the masked bits 724 may be stored in memory. Given k information bits, the permutation pattern 722 may define, indicate, or store an index to one permutation of all permutations of k information bits (e.g., an index to one permutation of all k! permutations). For example, the permutation pattern 722 may indicate one of 1, 2, ..., k!, each of which indicates a permutation of k information bits. The bitmask 724 may be an array of bits whose size is equal to k information bits such that each bit of the bitmask indicates whether to keep or clear the corresponding bit of the k information bits. The information bits optimizer 720 may be configured to perform bitwise or bit operations (e.g., NOT, AND, OR, XOR, shift, swap, etc.) to perform permutation (using the permutation pattern $\Pi$) and/or bitmasking (using the bitmask) on the k information bits.

The multi-rate LDPC generator/encoder 700 may obtain data of coded bit error rate (BER) and/or frame error probability (from past measurements or simulations for example), and determine, based on the bit error rates and/or frame error probability and prior to generating multi-rate LDPC codes, the permutation pattern 722 and/or the bitmask 724. The multi-rate LDPC generator/encoder 700 may determine the permutation pattern 722 to reduce the BER or FEP (e.g., by permuting particular bits that are highly affected by BER or FEP). The multi-rate LDPC generator/encoder 700 may determine the bitmask 724 to reduce the BER or FEP (e.g., by clearing particular bits that are highly affected by BER or FEP).

The multi-rate LDPC generator/encoder 700 can monitor data streams (e.g., transmission of digitally encoded signals) over a communication channel, determine or measure a coded BER and/or an FEP from the monitored data streams, and use the measured coded BER and/or an FEP to dynamically determine the permutation pattern 722 and/or the bitmask 724. The multi-rate LDPC generator/encoder 700 can be tunable to set the permutation pattern 722 and/or the bitmask 724 to different pattern/bitmasking values.

The multi-rate LDPC generator/encoder 700 may receive/determine/identify a desired code rate (or target code rate) denoted by r (e.g., r=1/3) and a (base) code rate of a base LDPC code (e.g., R=1/2). The multi-rate LDPC generator/encoder 700 may first determine a target code rate r and then determine, based on the target code rate r, a base code rate R (or one or more base code rates). Alternatively, the multi-rate LDPC generator/encoder 700 may first determine a base code rate R and then determine, based on the base code rate R, a target code rate r (or one or more target code rates).

The multi-rate LDPC generator/encoder 700 may determine, based on the base code rate (e.g., R=1/2), values of k and n (e.g., k=822, n=1944). The base LDPC code may have (or be associated with) a code rate R, a codeword length (or coded block length) n, and an information bits size k (e.g., n=648,1296,1944,3888 if the base code is chosen from the 802.11n-be standards).

The multi-rate LDPC generator/encoder 700 may determine a parameter of $\acute{k}$ indicating the size of information bits ($\acute{k} < k$; e.g., $\acute{k} = 486$) for the target rate r (e.g., r=1/3). The parameter $\acute{k}$ may be chosen a priori for a target rate r. The multi-rate LDPC generator/encoder 700 may determine the value of $\acute{k}$ using Equation 14. The multi-rate LDPC generator/-encoder 700 may determine a parameter of $\acute{n}$ indicating a coded block length (or codeword size; e.g., $\acute{n}$ =1458) for the target rate r (e.g., r=1/3). The multi-rate LDPC generator/encoder 700 may determine the value of $\acute{n}$ using Equation 15. The multi-rate LDPC generator/encoder 700 may determine a parameter of $(k - \acute{k})$ indicating a frozen block length or a size of one or more bits added to the $\acute{k}$ information bits $(k - \acute{k} = 486)$ for the target rate r (e.g., r=1/3). The multi-rate LDPC generator/encoder 700 may determine the parameter $(k - \acute{k})$ using Equation 16. With the parameters determined above (e.g., k, $\acute{n}$), the target rate r can be calculated using Equation 17.

The multi-rate LDPC generator/encoder 700 may calculate/compute/obtain possible combinations of parameters (e.g., r, R, $\acute{n}$, $\acute{k}$) using Equation 14 to Equation 17 (such that $\acute{n}$, $\acute{k}$ should be integer values), store the resulting parameter combinations in memory (e.g., in the form of look-up table (LUT)) as shown in Table 1, and determine parameters by selecting a parameter combination from the LUT. Using Table 1, the multi-rate LDPC generator/encoder 700 can first determine a target code rate r and then determine/select/choose, based on the target code rate r, one or more base code rates R. Using Table 1, the multi-rate LDPC generator/encoder 700 can first determine a base code rate R and then determine, based on the base code rate R, one or more target code rates.

The multi-rate LDPC generator/encoder 700 may receive k information bits 701 for the target code rate r. Next, the multi-rate LDPC generator/encoder 700 may add (k - $\acute{k}$) bits 702 to the $\acute{k}$ information bits at the end thereof to form/generate k information bits 710 for the base code rate R. The added $(k - \acute{k})$ bits 702 may be zero (e.g., $(k - \acute{k})$ number of binary zeros). The added $(k - \acute{k})$ bits 702 may include one or more binary ones.

In response to adding $(k - \acute{k})$ bits 702 to the $\acute{k}$ information bits 701, the information bits optimizer 720 may receive the resulting k information bits 710, perform at least one of permutation using the permutation pattern Π (722) or bitmasking using the bitmask 724, and generate optimized k information bits. The multi-rate LDPC generator/encoder 700 may control the information bits optimizer 720 to dynamically turn on or off, thereby selectively skipping permutation and/or bitmasking for simplicity without overly compromising the performance of the resulting multi-rate code. The multi-rate LDPC generator/encoder 700 may determine a degree of coded BER or FEP is less than a threshold, and turn off the information bits optimizer 720 to skip permutation and bitmasking.

In response to the information bits optimizer 720 generating the optimized k information bits (or in response to adding $(k - \acute{k})$ bits 702 to the $\acute{k}$ information bits 701 if the information bits optimization is skipped), the LDPC encoder may receive k information bits, and encode the k information bits to generate k encoded bits (not shown) and (n-k) parity bits 750. In response to generating the (n-k) parity bits 750, the MUX 760 may receive, as two inputs, the $\acute{k}$ information bits 701 and the (n-k) parity bits 750, and generate/output (n - k + $\acute{k}$) bits 780 by concatenating (or combining, merging, integrating, consolidating) the $\acute{k}$ information bits 701 and the (n-k) parity bits 750. The output (n - k + $\acute{k}$) bits 780 may correspond to a codeword for the multi-rate LDPC code with target rate r. In other words, the multi-rate LDPC encoder 700 can encode the k information bits 701 to generate the (n - k + $\acute{k}$) encoded bits 780 (or a codeword) such that the code rate of the multi-rate LDPC encoder 700 corresponds to

$$r = \frac{\acute{k}}{\text{n}-\text{k}+\acute{k}} \text{ (Equation 17)}.$$

.

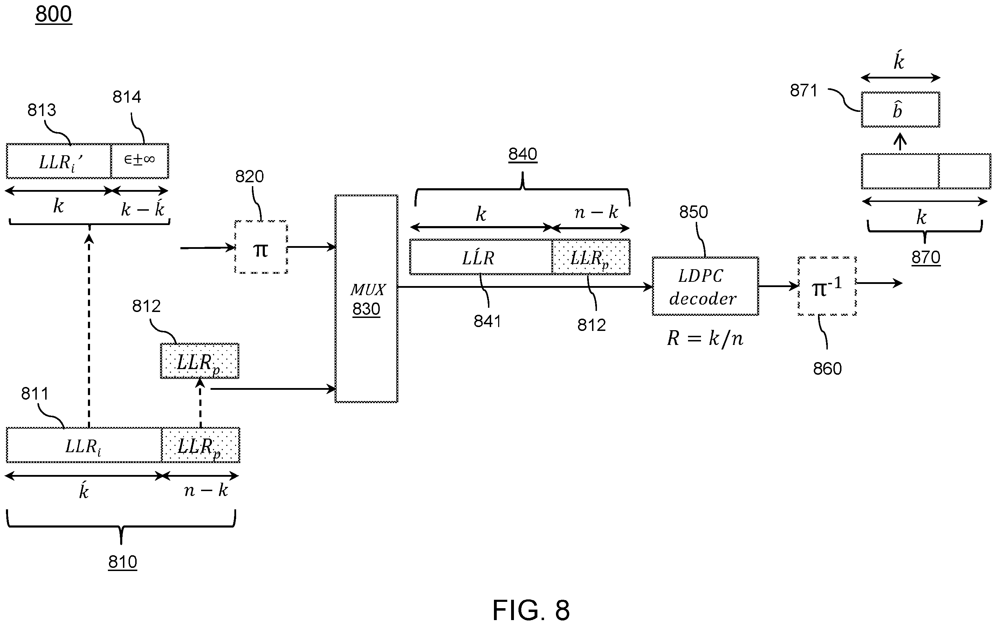

FIG. 8 is a diagram depicting an example multi-rate LDPC decoder 800 according to one or more embodiments. The multi-rate LDPC decoder 800 may include an LDPC decoder 850, a LLR values optimizer 820, a multiplexer (MUX) 830, and/or a bits de-optimizer (or inverse optimizer) 860. The multi-rate LDPC decoder 800 and each component thereof may be implemented using circuitry, firmware and/or software. For example, the multi-rate LDPC decoder 800 may be implemented in the decoder 160 of the communication system 108. In response to the communication system 105 transmitting encoded bits produced by the multi-rate LDPC encoder 700, the communication system 108 may receive the transmitted encoded bits and the multi-rate LDPC decoder 800 of the communication system 108 may decode LLR values corresponding to the transmitted encoded bits (e.g., LLR values 810). The LDPC decoder 850 may take a block of $n$ encoded bits and produce $k$ decoded bits (or decoded information bits) with the code rate R=k/n.

Referring to FIG. 8, the LLR values optimizer 820 may have configuration similar to the information bits optimizer in the multi-rate LDPC encoder. For example, the LLR values optimizer 820 may be configured to perform permutation (using a permutation pattern $\Pi$) and/or bitmasking (using a bitmask) on input LLR values (e.g., k LLR values). The bits de-optimizer 860 may be configured to perform an inverse operation of the information bits optimizer (e.g., information bits optimizer 720) in the corresponding multi-rate LDPC encoder (e.g., multi-rate LDPC encoder 700).

The multi-rate LDPC decoder 800 may receive $(n - k + \acute{k})$ log likelihood ratio (LLR) values 810 including $k$ LLR values 811 (corresponding to $\acute{k}$ information bits) and $(n-k)$ LLR values 812 (corresponding to $(n-k)$ parity bits). The multi-rate LDPC decoder 800 may obtain/extract, from the $\acute{k}$ LLR values 811, $k$ LLR values 813 by removing $(k - \acute{k})$ LLR values 814 at the end of the $\acute{k}$ LLR values 811. The removed $(k - \acute{k})$ LLR values 814 may correspond to the $(k - \acute{k})$ bits 702 (e.g., $(k - \acute{k})$ zeros) added to the $\acute{k}$ information bits 701 by the corresponding multi-rate LDPC encoder 700.

The multi-rate LDPC decoder 800 may generate, by the LLR values optimizer 820, k optimized LLR values. The multi-rate LDPC decoder 800 may turn off the LLR values optimizer 820 to skip permutation and bitmasking.

In response to the LLR values optimizer 720 generating the optimized k optimized LLR values 841 (or in response to extracting, from the $\acute{k}$ LLR values 811, $k$ LLR values 813 if the LLR values optimization is skipped), the MUX 830 may receive, as two inputs, the k (optimized) LLR values 841 and the $(n-k)$ LLR values 812, and generate/output n LLR values 840 by concatenating (or combining, merging, integrating, consolidating) the $k$ LLR values 841 and the $(n-k)$ LLR values 812.

The LDPC decoder 850 may receive the $n$ LLR values 840 as an output from the MUX 830, and decode the $n$ LLR values 840 to generate $k$ information bits. In response to determining that the corresponding multi-rate LDPC encoder 700 has performed the information bits optimization, the bits de-optimizer 860 may be configured to receive the k information bits from the LDPC decoder 850, and perform, based on the permutation pattern $\Pi$ (722) or the bitmask (724) in the multi-rate LDPC encoder 700, bitwise or bit operations to perform an inverse permutation and/or inverse bitmasking on input bits (e.g., k information bits). If the corresponding multi-rate LDPC encoder 700 does not perform the information bits optimization, the multi-rate LDPC decoder 800 may not perform the inverse bits optimization (e.g., by turning off the bits de-optimizer).

In some implementations, in response to the bits de-optimizer 860 generating the de-optimized $k$ information bits 870 (or in response to the LDPC decoder 850 generating the $k$ information bits if the corresponding multi-rate LDPC encoder 700 does not perform the information bits optimization), the multi-rate LDPC decoder 800 may extract, from the k information bits 870, $\acute{k}$ information bits 871 at the start of the k information bits 870, and output the $\acute{k}$ information bits 871. The outputted $\acute{k}$ information bits 871 may correspond to information bits for the multi-rate LDPC code with target rate r. In other words, the multi-rate LDPC decoder 800 can decode the $(n - k + \acute{k})$ LLR values 810 to generate the $\acute{k}$ information bits 871 such that the code rate of the multi-rate LDPC decoder 800 corresponds to

$$r = \frac{\acute{k}}{n-k+\acute{k}} \text{ (Equation 17).}$$

.

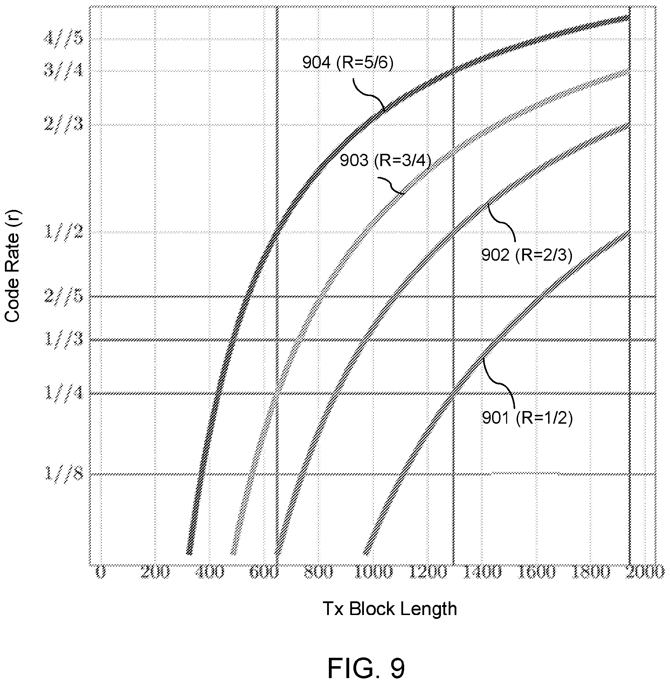

FIG. 9 is a diagram depicting target rates achieved (r) over different transmitted codeword sizes ($\acute{n}$) according to one or more embodiments. Referring to FIG. 9, lines 901, 902, 903, 904 correspond to target rates achieved (r) using different base rates of (1) R=1/2, (2) R=2/3, (3) R=3/4, (4) R=5/6, respectively.

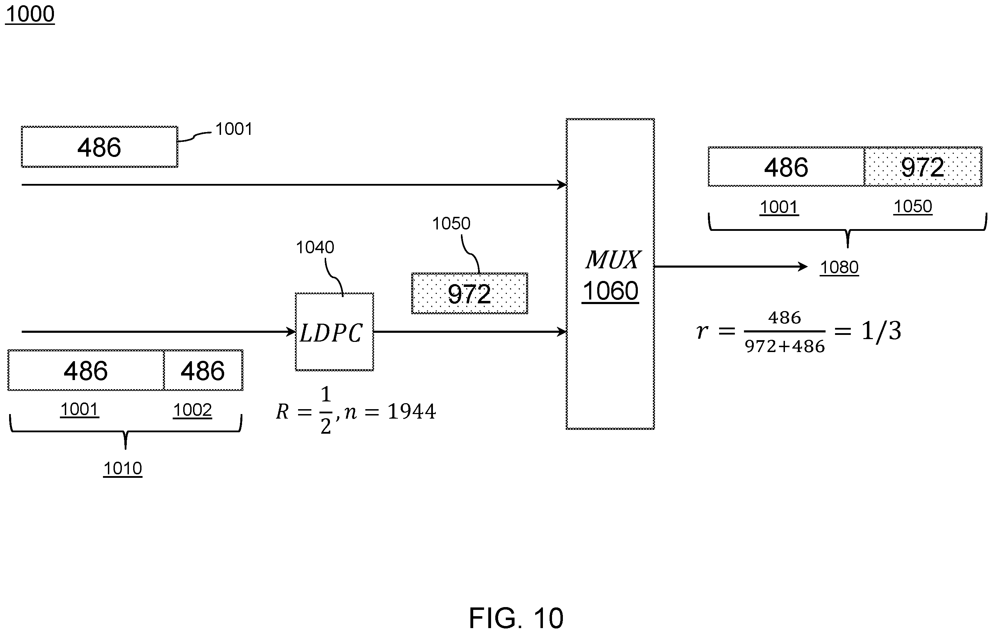

FIG. 10 is a diagram depicting an example multi-rate LDPC generator/encoder 1000 with an example code rate (e.g., r=1/3, R=1/2), according to one or more embodiments. Referring to FIG. 10, the multi-rate LDPC generator/encoder 1000 may receive $\acute{k}$ information bits 1001 (e.g., 486 information bits), and add (k-k) bits 1002 (e.g., 486 bits 1002) to the $\acute{k}$ information bits 1001 to generate k information bits 1010 (e.g., 972 information bits). An LDPC encoder 1040 may receive the 972 information bits 1010 and produce n encoded bits (e.g., 1944 encoded bits) including 972 parity bits 1050, according to the base code rate R=1/2. A MUX 1060 may concatenate the 486 information bits 1001 and the 972 parity bits 1050 to produce (1458=486+972) encoded bits 1080. In other words, the multi-rate LDPC encoder 1000 can encode 486 information bits 1001 to generate 1458 encoded bits 1080 (or a codeword) such that the code rate r of the multi-rate LDPC encoder 1000 corresponds to $\frac{1}{3} = \frac{486}{1458}$.

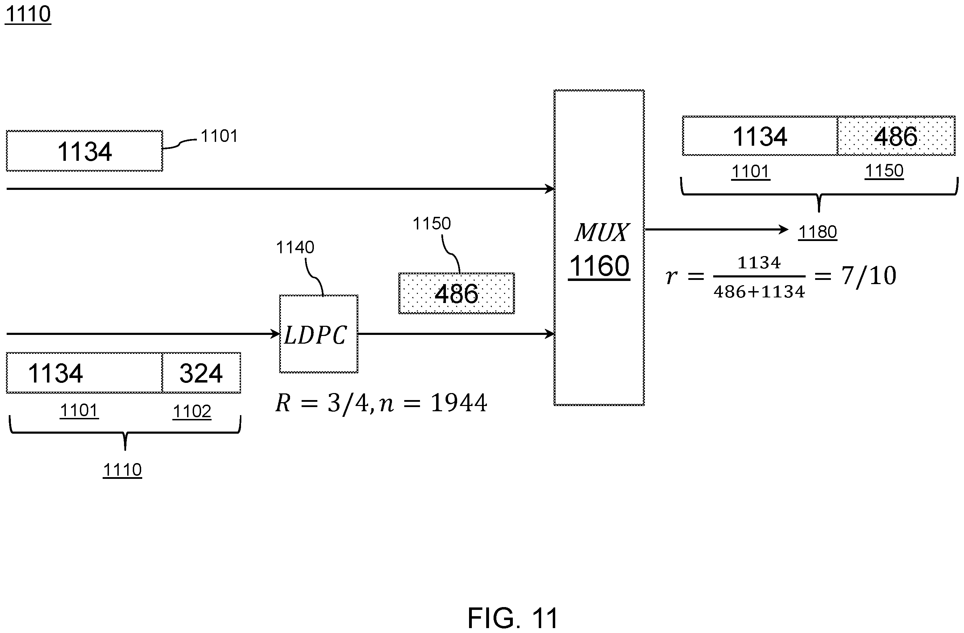

FIG. 11 is a diagram depicting an example multi-rate LDPC generator/encoder 1100 with another example code rate (e.g., r=7/10, R=3/4), according to one or more embodiments. Referring to FIG. 11, the multi-rate LDPC generator/-encoder 1100 may receive $\acute{k}$ information bits 1101 (e.g., 1134 information bits), and add $(k-\acute{k})$ bits 1102 (e.g., 324 bits 1102) to the $\acute{k}$ information bits 1101 to generate k information bits 1110 (e.g., 1458 information bits). An LDPC encoder 1140 may receive the 1458 information bits 1110 and produce n encoded bits (e.g., 1944 encoded bits) including 486 parity bits 1150, according to the base code rate R=3/4. A MUX 1160 may concatenate the 1134 information bits 1101 and the 486 parity bits 1150 to produce (1620=1134 +486) encoded bits 1180. In other words, the multi-rate LDPC encoder 1100 can encode 1134 information bits 1101 to generate 1620 encoded bits 1180 (or a codeword) such that the code rate *r* of the multi-rate LDPC encoder 1000 corresponds to $\frac{7}{10} = \frac{1134}{1620}$.

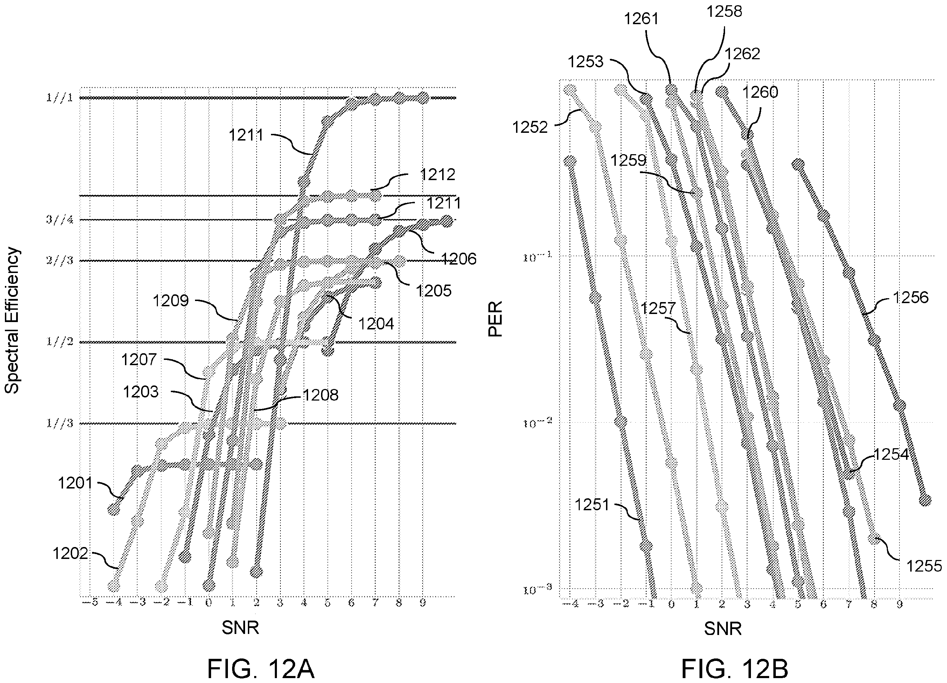

FIGS. 12A, 12B, 13A, 13B, 14A, 14B, 15A and 15B are diagrams depicting example simulation results according to one or more embodiments. The results were obtained with the following channel models. Channel models includes (1) "DNLOS" indicating a 802.11 MIMO (multiple input multiple output) channel model type D which is non-line of sight; (2) "BLOS" indicating a 802.11 channel model Type B which is line of sight; and (3) AWGN indicating a flat channel with additive white gaussian noise. No radio frequency (RF) impairments are included. PER refers to the number of error packets divided by the total number of received packets. SpecEff refers to an information rate (or bit rate or effective data rate) over a given bandwidth in a communication system (in the unit of bits/second/Hz). SpecEff may be a normalized rate of transmission such that the actual transmission rate (bits/second) = SpecEff x bandwidth (Hz). SNR refers to a signal to noise ratio.

FIG. 12A and FIG. 12B are diagrams depicting example simulation results using different code rates on a 1x1 SISO (single input single output) channel with DNLOS signal propagation. Referring to FIG. 12A, lines 1201, 1202, 1203, 1204, 1205, 1206, 1207, 1208, 1209, 1210, 1211, 1212 correspond to simulation results (SpecEff vs SNR) using modulation configurations of (1) Binary Phase-shift keying (BPSK) , R=1/4, (2) BPSK, R=1/3, (3) BPSK, R=1/2, (4) BPSK, R=5/8, (5) BPSK, R=2/3, (6) BPSK, R=3/4, (7) Quadrature Phase Shift Keying (QPSK), R=1/4, (8) QPSK, R=5/16, (9) QPSK, R=1/3, (10) QPSK, R=1/2, (11) QPSK, R=3/8, (12) QPSK, R=2/5, respectively. Referring to FIG. 12B, lines 1251, 1252, 1253, 1254, 1255, 1256, 1257, 1258, 1259, 1215, 1211, 1212 correspond to simulation results (PER vs SNR) using modulation configurations of (1) BPSK, R=1/4, (2) BPSK, R=1/3, (3) BPSK, R=1/2, (4) BPSK, R=5/8, (5) BPSK, R=2/3, (6) BPSK, R=3/4, (7) QPSK, R=1/4, (8) QPSK, R=5/16, (9) QPSK, R=1/3, (10) QPSK, R=1/2, (11) QPSK, R=3/8, (12) QPSK, R=2/5, respectively.

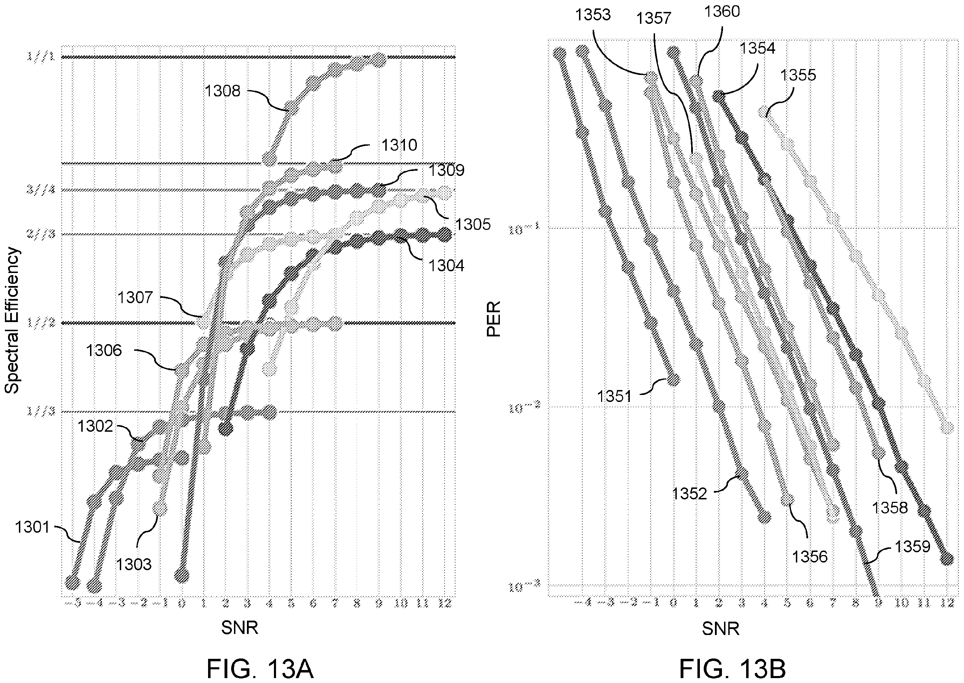

FIG. 13A and FIG. 13B are diagrams depicting example simulation results using different code rates on a 1x1 SISO channel with BLOS signal propagation. Referring to FIG. 13A, lines 1301, 1302, 1303, 1304, 1305, 1306, 1307, 1308, 1309, 1310 correspond to simulation results (SpecEff vs SNR) using modulation configurations of (1) BPSK, R=1/4, (2) BPSK, R=1/3, (3) BPSK, R=1/2, (4) BPSK, R=2/3, (5) BPSK, R=3/4, (6) QPSK, R=1/4, (7) QPSK, R=1/3, (8) QPSK, R=1/2, (9) QPSK, R=3/8, (10) QPSK, R=2/5, respectively. Referring to FIG. 13B, lines 1351, 1352, 1353, 1354, 1355, 1356, 1357, 1358, 1359, 1360 correspond to simulation results (PER vs SNR) using modulation configurations of (1) BPSK, R=1/4, (2) BPSK, R=1/3, (3) BPSK, R=1/2, (4) BPSK, R=2/3, (5) BPSK, R=3/4, (6) QPSK, R=1/4, (7) QPSK, R=1/3, (8) QPSK, R=1/2, (9) QPSK, R=3/8, (10) QPSK, R=2/5, respectively.

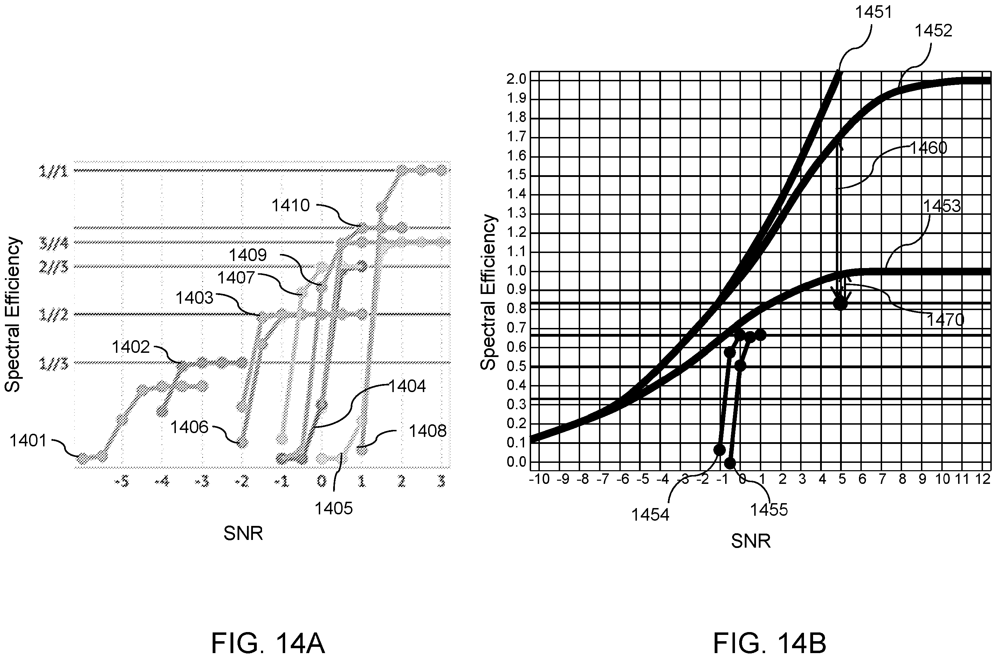

FIG. 14A and FIG. 14B are diagrams depicting example simulation results with different modulation configurations, according to one or more embodiments. FIG. 14A is a diagram depicting example simulation results using different code rates on a 1x1 SISO (single input single output) additive white Gaussian noise (AWGN) channel, according to one or more embodiments. Referring to FIG. 14A, lines 1401, 1402, 1403, 1404, 1405, 1406, 1407, 1408, 1409, 1410 correspond to simulation results (SpecEff vs SNR) using modulation configurations of (1) BPSK, R=1/4, (2) BPSK, R=1/3, (3) BPSK, R=1/4, R=1/2, (4) BPSK, R=2/3, (5) BPSK, R=3/4, (6) QPSK, R=1/4, (7) QPSK, R=1/3, (8) QPSK, R=1/2, (9) QPSK, R=3/8, (10) QPSK, R=2/5, respectively.

As shown in FIG. 14A, in ELR (Extended Long Range) communication schemes, QPSK with R=1/3 performs significantly better than BPSK with R=2/3. The error probability $\varepsilon$ with a code rate R, a codeword size n, and SNR=snr can be calculated as follows:

$$\varepsilon(R, n, snr) = Q\left(\frac{C-R}{\beta\sqrt{\frac{V(snr)}{n}}}\right) \dots\dots\dots\dots \text{(Equation 18)},$$

where Q is a Gaussian error probability function; C is a channel capacity; $\beta$ is a constant (e.g., $\beta$=2). For example, the error probability $\varepsilon$ with R=2/3, n=1944, snr=1 on a BPSK channel ($C_{BPSK}$=0.72) can be calculated as follows:

$$\varepsilon\left(\frac{2}{3}, 1944, 1\right) = Q\left(\frac{C_{BPSK} - \frac{2}{3}}{2\sqrt{\frac{1}{1944}}}\right) = 0.2928 \dots\dots\dots\dots \text{ (Equation 19)},$$

On the other hand, the error probability $\varepsilon$ with R=1/3, n=1944, snr=1 on a QPSK channel ($C_{QPSK}$=0.72) can be calculated as follows:

$$\varepsilon\left(\frac{1}{3}, 1944, 1\right) = Q\left(\frac{C_{QPSK} - \frac{1}{3}}{2\sqrt{\frac{1}{1944}}}\right) = 5.18x10^{-7} \dots\dots\dots\dots \text{ (Equation 20)},$$

As the error probability on a QPSK channel with R=1/3 (see Equation 20) is significantly less than the error probability on a BPSK channel with R=2/3 (see Equation 19), QPSK with R=1/3 performs significantly better than BPSK with R=2/3.

FIG. 14B is a diagram showing that an optimum modulation code rate may depend on gaps to a channel capacity. Referring to FIG. 14B, lines 1451, 1452, 1453, 1454, 1455 correspond to simulation/theoretical results (SpecEff vs SNR) using modulation configurations of (1) Shannon limit, (2) bit-interleaved coded modulation (BICM)-QPSK, (3) BICM-BPSK, (4) QPSK, LDPC (n=1944, R=1/3), (5) BPSK, LDPC (n=1944, R=2/3), respectively. Shannon limit (or Shannon capacity) refers to a maximum rate of error-free data that can theoretically be transferred over the channel if the link is subject to random data transmission errors, for a particular noise level. The Shannon limit is a fundamental limit of a channel, which is achieved when the distribution of a code matches to an optimum distribution for a given channel. For QPSK modulations, an optimum modulation code rate R may depend on a gap $G_{QPSK}$=R-$C_{QPSK}$. FIG. 14B shows the gap $G_{QPSK}$ 1460 with R=5/6≈0.83. Similarly, For BPSK modulations, an optimum modulation code rate R may depend on a gap $G_{BPSDK}$=R-$C_{BPSK}$. FIG. 14B shows the gap $G_{BPSK}$ 1470 with R=5/6≈0.83.

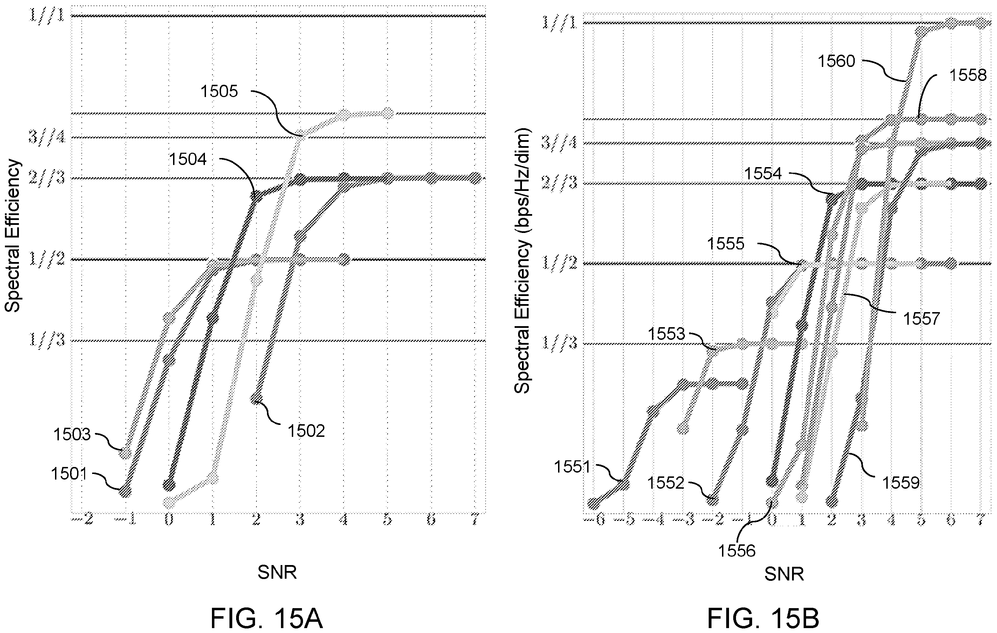

FIG. 15A and FIG. 15B are diagrams depicting example simulation results with different code rates, according to one or more embodiments. FIG. 15A shows simulation results using different code rates on a 4x2 MIMO (multiple input multiple output) TxBF (transmit beamforming) channel with DNLOS signal propagation. Referring to FIG. 15A, lines 1501, 1502, 1503, 1504, 1505 correspond to simulation results (SpecEff vs SNR) using modulation configurations of (1) BPSK, R=1/2, (2) BPSK, R=2/3, (3) QPSK, R=1/4, (4) QPSK, R=1/3, (5) QPSK, R=2/5, respectively. Table 2 shows comparison of two configurations (columns of "config-1" and "config-2") and which configuration shows better performance ("winner" column).

Table 2. Comparison between Different Modulation Configurations

| config-1 | config-2 | Winner |
|---|---|---|
| BPSK, R=½ (MCS0) | QPSK, R=1/4 | QPSK, R=1/4 |
| BPSK, R=2/3 | QPSK,R=1/3 | QPSK,R=1/3 |
| BPSK, R = 3/4 | QPSK, R=3/8 | QPSK, R=3/8 |
| QPSK, R ~ 3//8 | QPSK, R= 2/5 | QPSK, R=2/5 |

FIG. 15B shows simulation results using different code rates on a 2x2 MIMO channel with DNLOS signal propagation. Referring to FIG. 15B, lines 1551, 1552, 1553, 1554, 1555, 1556, 1557, 1558, 1559, 1560 correspond to simulation results (SpecEff vs SNR) using modulation configurations of (1) BPSK, R=1/4, (2) QPSK, R=1/4, (3) BPSK, R=1/3, (4) QPSK, R=1/3, (5) BPSK, R=1/2, (6) QPSK, R=3/8, (7) BPSK, R=2/3, (8) QPSK, R=2/5, (9) BPSK, R=3/4, (10) QPSK, R=1/2, respectively. Table 3 shows comparison of two configurations (columns of "config-1" and "config-2") and which configuration shows better performance ("winner" column).

Table 3. Comparison between Different Modulation Configurations

| config-1 | config-2 | Winner |
|---|---|---|
| BPSK, R=½ (MCS0) | QPSK, R=1/4 | QPSK, R=1/4 |
| BPSK, R=2/3 | QPSK, R=1/3 | QPSK, R=1/3 |

(continued)

| config-1 | config-2 | Winner |
|---|---|---|
| BPSK, R = 3/4 | QPSK, R=3/8 | QPSK, R=3/8 |
| QPSK, R= 3/8 | QPSK, R= 2/5 | QPSK, R=2/5 |

In some implementations, an apparatus (e.g., communication system 105) may include a transmitter (e.g., transmitter circuitry 120) and one or more processors (e.g., processor 2010). The one or more processors may be configured to identify a low density parity check (LDPC) code that has a base code rate (e.g., code rate R) for a base size of information bits (e.g., information bits size k). The one or more processors may be configured to select, based at least on the base code rate, a target code rate (denoted by r) and a first size of information bits (e.g., $\acute{k}$) that is less than the base size of information bits (e.g., $\acute{k} < k$). The one or more processors may be configured to generate a second set of information (e.g., information bits 710) to include a first set of information bits (e.g., information bits 701) corresponding to the first size of information bits and one or more bits (e.g., bits 702) to increase a size of the second set of information to correspond to the base size of information bits (e.g., k). The one or more processors may be configured to encode, using the base code rate R, the second set of information bits to generate parity data (e.g., parity bits 750). The one or more processors may be configured to generate a codeword (e.g., codeword 780) by concatenating the first set of information bits (e.g., information bits 701) and the parity data (e.g., parity bits 750) to achieve the target code rate r. The transmitter may be configured to transmit the codeword 780.

In some implementations, the target code rate r may be smaller than the base code rate R. In some implementations, in generating the second set of information bits (e.g., information bits 710), the one or more processors may be configured to determine, based at least on the target data rate r and the base code rate R, a second size of the one or more bits (e.g., determining the size ($k$-k) using Equation 16). The one or more processors may be configured to generate the one or more bits corresponding to the second size of the one or more bits.

In some implementations, the one or more processors may be configured to determine, based at least on a coded bit error rate or a frame error probability, a set of masked bits (e.g., bitmask 724) corresponding to the base size of information bits (e.g., k). The one or more processors may be configured to generate, based at least on the set of masked bits and the second set of information bits (e.g., information bits 710), a third set of information bits corresponding to the base size of information bits. The one or more processors may be configured to encode, using the base code rate R, the third set of information bits to generate second parity data (e.g., parity bits 750). The one or more processors may be configured to generate the codeword by concatenating the first set of information bits (e.g., information bits 701) and the second parity data (e.g., parity bits 750) to achieve the target code rate r.

In some implementations, a ratio of the first size of information bits (e.g., $\acute{k}$) to a size of the codeword (e.g., $n-k+k$) may be equal to the target code rate r (Equation 17). In some implementations, the one or more processors may be configured to identify, based at least on the base code rate R, one or more target code rates r to be achieved using the base code rate. Each of the one or more target code rates may be different from the target code rate. See Table 1 which shows there are multiple target code rates corresponding to a single base code rate R.

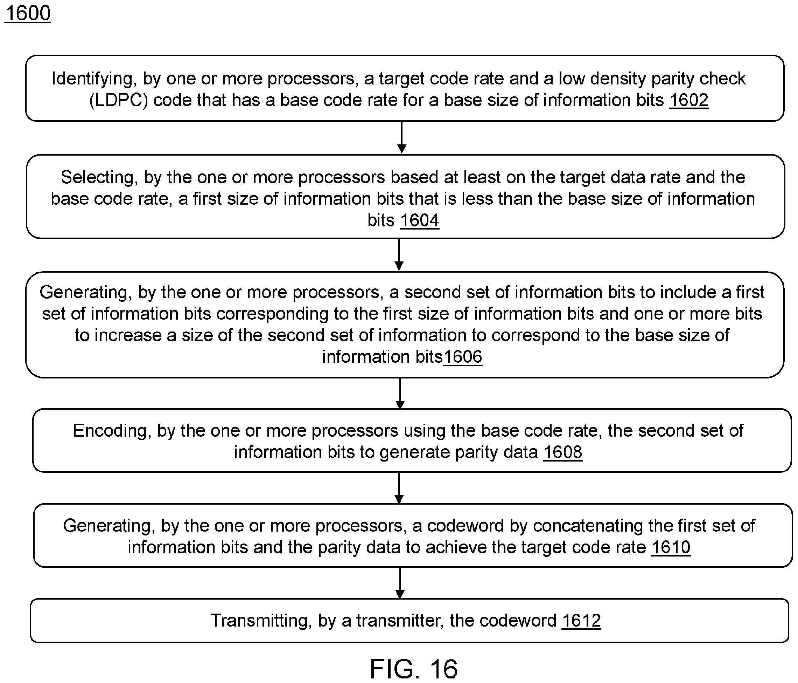

FIG. 16 is a flow diagram showing a process 1600 for encoding with multi-rate LDPC codes, in accordance with an embodiment. In some implementations, the process 1600 is performed by one or more processors of a device (e.g. encoder 130 or processor 2010 of communication system 105). In other embodiments, the process 1300 is performed by other entities (e.g., a computing system other than the communication system 105). In some implementations, the process 1600 includes more, fewer, or different steps than shown in FIG. 16.

At step 1602, the device may identify a target code rate (denoted by r) and an LDPC code that has a base code rate (denoted by R) for a base size of information bits (denoted by k). In some implementations, the target code rate (r) may be smaller than the base code rate (R).

At step 1604, the device may select, based at least on the target data rate r and the base code rate R, a first size of information bits (e.g., $\acute{k}$) that is less than the base size of information bits (e.g., $k$).

At step 1606, the device may generate a second set of information bits (e.g., information bits 710) to include a first set of information bits corresponding to the first size of information bits (e.g., information bits 701) and one or more bits (e.g., bits 702) to increase a size of the second set of information to correspond to the base size of information bits (e.g., $k$). In some implementations, in generating the second set of information bits (e.g., information bits 710), the device may determine, based at least on the target data rate r and the base code rate R, a second size of the one or more bits (e.g., determining the size ($k$-$\acute{k}$) using Equation 16). The device may generate the one or more bits corresponding to the second size of the one or more bits.

At step 1608, the device may encode, using the base code rate R, the second set of information bits to generate parity data (e.g., parity bits 750). In some implementations, the device may encode, using the identified LDPC code, the second set of information bits to generate the parity data.

At step 1610, the device may generate a codeword (e.g., codeword 780) by concatenating the first set of information bits (e.g., information bits 701) and the parity data (e.g., parity bits 750) to achieve the target code rate r. At step 1610, a transmitter (e.g., transmitter circuitry 120) may transmit the codeword. In some implementations, a ratio of the first size of information bits (e.g., $\acute{k}$) to a size of the codeword (e.g., $n-k+\acute{k}$) may be equal to the target code rate r (Equation 17).

In some implementations, the device may determine, based at least on a coded bit error rate (BER) or a frame error probability (FEP), a set of masked bits (e.g., bitmask 724) corresponding to the base size of information bits (e.g., k). The device may generate, based at least on the set of masked bits (e.g., bitmask 724) and the second set of information bits (e.g., information bits 710), a third set of information bits corresponding to the base size of information bits. The device may encode, using the base code rate R, the third set of information bits to generate second parity data (e.g., parity bits 750). The device may generate the codeword by concatenating the first set of information bits (e.g., information bits 701) and the second parity data (e.g., parity bits 750) to achieve the target code rate r.

In some implementations, the device may identify, based at least on the target code rate r, one or more LDPC codes to achieve the target code rate. Each of the one or more LDPC codes may have a base code rate different from the base code rate of the LDPC code, for a base size of information bits different from the base size of information bits of the LDPC code. See Table 1 which shows there are multiple base code rates R corresponding to a single target code rate r.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, In some implementations, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

**Claims**

1. An apparatus (105) comprising:

a transmitter (120) and one or more processors (2010), wherein
the one or more processors (2010) are configured to:

identify a target code rate and a low density parity check, LDPC, code that has a base code rate for a base size of information bits;
select, based at least on the target data rate and the base code rate, a first size of information bits that is less than the base size of information bits;
generate a second set of information bits to include a first set of information bits corresponding to the first size of information bits and one or more bits to increase a size of the second set of information to correspond to the base size of information bits;
encode, using the base code rate, the second set of information bits to generate parity data; and
generate a codeword by concatenating the first set of information bits and the parity data to achieve the target code rate,

wherein the transmitter (120) is configured to transmit the codeword.

2. The apparatus (105) of claim 1, wherein the target code rate is smaller than the base code rate.

3. The apparatus (105) of claim 1 or 2, wherein in generating the second set of information bits, the one or more processors (2010) are configured to:

> determine, based at least on the target data rate and the base code rate, a second size of the one or more bits; and
> generate the one or more bits corresponding to the second size of the one or more bits.

4. The apparatus (105) of any of claims 1 to 3, wherein the one or more processors (2010) are further configured to:

> determine, based at least on a coded bit error rate or a frame error probability, a set of masked bits corresponding to the base size of information bits;
> generate, based at least on the set of masked bits and the second set of information bits, a third set of information bits corresponding to the base size of information bits;
> encode, using the base code rate, the third set of information bits to generate second parity data; and
> generate the codeword by concatenating the first set of information bits and the second parity data to achieve the target code rate.

5. The apparatus (105) of any of claims 1 to 4, wherein the second set of information bits are encoded using the identified LDPC code to generate the parity data.

6. The apparatus (105) of any of claims 1 to 5, wherein a ratio of the first size of information bits to a size of the codeword is equal to the target code rate.

7. The apparatus (105) of any of claims 1 to 6, wherein the one or more processors (2010) are further configured to:

> identify, based at least on the target code rate, one or more LDPC codes to achieve the target code rate, wherein each of the one or more LDPC codes has a base code rate different from the base code rate of the LDPC code, for a base size of information bits different from the base size of information bits of the LDPC code.

8. A method comprising:

> identifying, by one or more processors (2010), a target code rate and a low density parity check, LDPC, code that has a base code rate for a base size of information bits;
> selecting, by the one or more processors (2010) based at least on the target data rate and the base code rate, a first size of information bits that is less than the base size of information bits;
> generating, by the one or more processors (2010), a second set of information bits to include a first set of information bits corresponding to the first size of information bits and one or more bits to increase a size of the second set of information to correspond to the base size of information bits;
> encoding, by the one or more processors (2010) using the base code rate, the second set of information bits to generate parity data;
> generating, by the one or more processors (2010), a codeword by concatenating the first set of information bits and the parity data to achieve the target code rate; and
> transmitting, by a transmitter (120), the codeword.

9. The method of claim 8, wherein the target code rate is smaller than the base code rate.

10. The method of claim 8 or 9, wherein generating the second set of information bits comprises:

> determining, based at least on the target data rate and the base code rate, a second size of the one or more bits; and
> generating the one or more bits corresponding to the second size of the one or more bits.

11. The method of any of claims 8 to 10, further comprising:

> determining, based at least on a coded bit error rate or a frame error probability, a set of masked bits corresponding to the base size of information bits;

generating, based at least on the set of masked bits and the second set of information bits, a third set of information bits corresponding to the base size of information bits;

encoding, using the base code rate, the third set of information bits to generate second parity data; and generating the codeword by concatenating the first set of information bits and the second parity data to achieve the target code rate.

12. The method of any of claims 8 to 11, comprising at least one of the following features:

i) wherein the second set of information bits are encoded using the identified LDPC code to generate the parity data;

ii) wherein a ratio of the first size of information bits to a size of the codeword is equal to the target code rate.

13. The method of any of claims 8 to 12, further comprising:

identifying, based at least on the target code rate, one or more LDPC codes to achieve the target code rate, wherein each of the one or more LDPC codes has a base code rate different from the base code rate of the LDPC code, for a base size of information bits different from the base size of information bits of the LDPC code.

14. An apparatus (105) comprising:

a transmitter (120) and one or more processors (2010), wherein
the one or more processors (2010) are configured to:

identify a low density parity check, LDPC, code that has a base code rate for a base size of information bits;
select, based at least on the base code rate, a target code rate and a first size of information bits that is less than the base size of information bits;
generate a second set of information to include a first set of information bits corresponding to the first size of information bits and one or more bits to increase a size of the second set of information to correspond to the base size of information bits;
encode, using the base code rate, the second set of information bits to generate parity data; and
generate a codeword by concatenating the first set of information bits and the parity data to achieve the target code rate,

wherein the transmitter (120) is configured to transmit the codeword.

15. The apparatus (105) of claim 14, comprising at least one of the following features:

i) wherein the target code rate is smaller than the base code rate;
ii) wherein in generating the second set of information bits, the one or more processors (2010) are configured to:

determine, based at least on the target data rate and the base code rate, a second size of the one or more bits; and
generate the one or more bits corresponding to the second size of the one or more bits;

iii) wherein the one or more processors (2010) are further configured to:

determine, based at least on a coded bit error rate or a frame error probability, a set of masked bits corresponding to the base size of information bits;
generate, based at least on the set of masked bits and the second set of information bits, a third set of information bits corresponding to the base size of information bits;
encode, using the base code rate, the third set of information bits to generate second parity data; and
generate the codeword by concatenating the first set of information bits and the second parity data to achieve the target code rate;

iv) wherein a ratio of the first size of information bits to a size of the codeword is equal to the target code rate;
v) wherein the one or more processors (2010) are further configured to:

identify, based at least on the base code rate, one or more target code rates to be achieved using the base code rate,

wherein each of the one or more target code rates is different from the target code rate.

**100**

**105**

Baseband
Circuitry
**110**

Encoder
**130**

Transmitter
Circuitry
**120**

*115*

*125*

**108**

Receiver
Circuitry
**140**

*145*

Baseband
Circuitry
**150**

Decoder
**160**

EP 4 611 265 A1

FIG. 1

EP 4 611 265 A1

**Computing system 2000**

```
┌──────────┐      ┌──────────┐     ┌──────────────┐
│  Cache   │◄────►│ Processor │     │ I/O Components│
│  2020    │      │   2010    │     │    2050       │
└──────────┘      └──────────┘     └──────────────┘
```

Display
2070

Input Device
2080

Communication System 2040

Memory
2060

Network Interface
Device 2030

FIG. 2

FIG. 3

7x7 SparseMatrixCSC{Int64, Int64} with 0 stored entries:

d=-1    ⌐ 409

7x7 SparseMatrixCSC{Bool, Int64} with 7 stored entries:

d=3    ⌐ 413

7x7 SparseMatrixCSC{Bool, Int64} with 7 stored entries:

d=0    ⌐ 410

7x7 SparseMatrixCSC{Bool, Int64} with 7 stored entries:

d=4    ⌐ 414

7x7 SparseMatrixCSC{Bool, Int64} with 7 stored entries:

d=1    ⌐ 411

7x7 SparseMatrixCSC{Bool, Int64} with 7 stored entries:

d=5    ⌐ 415

7x7 SparseMatrixCSC{Bool, Int64} with 7 stored entries:

d=2    ⌐ 412

7x7 SparseMatrixCSC{Bool, Int64} with 7 stored entries:

d=6    ⌐ 416

FIG. 4

EP 4 611 265 A1

FIG. 5

**600**

FIG. 6

EP 4 611 265 A1

FIG. 7

$$r = \frac{\acute{k}}{n-k+\acute{k}}$$

Target Code Rate

$$R = k/n$$

FIG. 8

FIG. 9

1000

486  — 1001

486  486
1001  1002

1010

LDPC  1040

$R = \frac{1}{2}, n = 1944$

972  1050

MUX
1060

486    972
1001    1050

1080

$r = \frac{486}{972+486} = 1/3$

FIG. 10

EP 4 611 265 A1

FIG. 11

$$r = \frac{1134}{486+1134} = 7/10$$

$$R = 3/4, n = 1944$$

EP 4 611 265 A1

FIG. 12B

FIG. 12A

FIG. 13A

FIG. 13B

FIG. 14A

FIG. 14B

EP 4 611 265 A1

FIG. 15A

FIG. 15B

EP 4 611 265 A1

**1600**

Identifying, by one or more processors, a target code rate and a low density parity check (LDPC) code that has a base code rate for a base size of information bits 1602

Selecting, by the one or more processors based at least on the target data rate and the base code rate, a first size of information bits that is less than the base size of information bits 1604

Generating, by the one or more processors, a second set of information bits to include a first set of information bits corresponding to the first size of information bits and one or more bits to increase a size of the second set of information to correspond to the base size of information bits1606

Encoding, by the one or more processors using the base code rate, the second set of information bits to generate parity data 1608

Generating, by the one or more processors, a codeword by concatenating the first set of information bits and the parity data to achieve the target code rate 1610

Transmitting, by a transmitter, the codeword 1612

FIG. 16

Europäisches
Patentamt

European
Patent Office

Office européen
des brevets

# EUROPEAN SEARCH REPORT

**Application Number**

EP 25 15 8885

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TIAN TAO ET AL: "Construction of Rate-Compatible LDPC Codes Utilizing Information Shortening and Parity Puncturing", EURASIP. JOURNAL ON WIRELESS COMMUNICATIONS AND NETWORKING, XX, XX, vol. 5, 1 January 2005 (2005-01-01), pages 789-795, XP002531349, DOI: 10.1155/WCN.2005.789 * cf. passages cited in search opinion * | 1,2, 5-10,12, 14,15 | INV. H03M13/11 H03M13/00 H04L1/00 |
| X | EP 2 320 574 A2 (BROADCOM CORP [US]) 11 May 2011 (2011-05-11)<br><br>* cf. passages cited in search opinion * | 1,2, 4-12,14, 15 | |
| X | EP 3 667 925 A2 (QUALCOMM INC [US]) 17 June 2020 (2020-06-17)<br><br>* cf. passages cited in search opinion * | 1-3, 5-10, 12-15 | |

| | |
|---|---|
| | TECHNICAL FIELDS SEARCHED (IPC) |
| | H03M H04L |

The present search report has been drawn up for all claims

| Place of search | Date of completion of the search | Examiner |
|---|---|---|
| Munich | 26 June 2025 | Wu, Zifeng |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 8885

This annex lists the patent family members relating to the patent documents cited in  the above-mentioned European search report.
The members are as contained in the European Patent Office EDP file on
The European Patent Office is in no way liable for these particulars which are merely given for the purpose of information.

26-06-2025

| Patent document cited in search report | | Publication date | Patent family member(s) | | Publication date |
|---|---|---|---|---|---|
| EP 2320574 | A2 | 11-05-2011 | CN | 101997645 A | 30-03-2011 |
| | | | EP | 2320574 A2 | 11-05-2011 |
| | | | HK | 1155584 A1 | 18-05-2012 |
| EP 3667925 | A2 | 17-06-2020 | AU | 2017285198 A1 | 29-11-2018 |
| | | | AU | 2017285200 A1 | 29-11-2018 |
| | | | BR | 112018075014 A2 | 19-03-2019 |
| | | | BR | 112018075015 A2 | 19-03-2019 |
| | | | CA | 3022825 A1 | 21-12-2017 |
| | | | CA | 3022954 A1 | 21-12-2017 |
| | | | CA | 3092706 A1 | 21-12-2017 |
| | | | CA | 3092783 A1 | 21-12-2017 |
| | | | CN | 109314525 A | 05-02-2019 |
| | | | CN | 109314526 A | 05-02-2019 |
| | | | CN | 110324046 A | 11-10-2019 |
| | | | CN | 110351013 A | 18-10-2019 |
| | | | CN | 114928364 A | 19-08-2022 |
| | | | EP | 3469712 A1 | 17-04-2019 |
| | | | EP | 3469713 A1 | 17-04-2019 |
| | | | EP | 3667925 A2 | 17-06-2020 |
| | | | EP | 3667926 A1 | 17-06-2020 |
| | | | EP | 3852276 A1 | 21-07-2021 |
| | | | EP | 4539342 A2 | 16-04-2025 |
| | | | JP | 6749427 B2 | 02-09-2020 |
| | | | JP | 7050853 B2 | 08-04-2022 |
| | | | JP | 2019518385 A | 27-06-2019 |
| | | | JP | 2020145739 A | 10-09-2020 |
| | | | SG | 11201809479P A | 28-12-2018 |
| | | | TW | 201803279 A | 16-01-2018 |
| | | | TW | 201803282 A | 16-01-2018 |
| | | | TW | 201939903 A | 01-10-2019 |
| | | | US | 2017359086 A1 | 14-12-2017 |
| | | | US | 2017359148 A1 | 14-12-2017 |
| | | | US | 2019199475 A1 | 27-06-2019 |
| | | | US | 2019245654 A1 | 08-08-2019 |
| | | | US | 2020052817 A1 | 13-02-2020 |
| | | | US | 2021058192 A1 | 25-02-2021 |
| | | | US | 2022224356 A1 | 14-07-2022 |
| | | | US | 2023275599 A1 | 31-08-2023 |
| | | | US | 2023327683 A1 | 12-10-2023 |
| | | | US | 2025112644 A1 | 03-04-2025 |
| | | | WO | 2017218665 A1 | 21-12-2017 |
| | | | WO | 2017218667 A1 | 21-12-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63558718